(19) Europäisches Patentamt
European Patent Office
Office européen des brevets

(11) Publication number: **0 324 482 B1**

(12) **EUROPEAN PATENT SPECIFICATION**

(45) Date of publication of patent specification: **31.03.93**

(51) Int. Cl.5: **G03F 7/027**

(21) Application number: **89100498.8**

(22) Date of filing: **12.01.89**

The file contains technical information submitted after the application was filed and not included in this specification

(54) **Process of forming reflection holograms in photopolymerizable layers.**

(30) Priority: **15.01.88 US 144840**

(43) Date of publication of application:
**19.07.89 Bulletin 89/29**

(45) Publication of the grant of the patent:
**31.03.93 Bulletin 93/13**

(84) Designated Contracting States:
**AT BE CH DE FR GB IT LI LU NL SE**

(56) References cited:
**EP-A- 0 003 040**
**WO-A-85/01127**
**US-A- 3 809 732**
**US-A- 4 173 474**
**EP-A- 0 155 652**
**US-A- 3 658 526**
**US-A- 3 993 485**
**US-A- 4 686 171**

(73) Proprietor: **E.I. DU PONT DE NEMOURS AND COMPANY**
**1007 Market Street**
**Wilmington Delaware 19898(US)**

(72) Inventor: **Keys, Dalen Eugene**
**R. D. No. 5 Box 260A2**
**Towanda Pennsylvania 18848(US)**
Inventor: **Smothers, William Karl**
**R. D. No.2 Box 103 Old Public Road**
**Hockessin Delaware 19707(US)**

(74) Representative: **Werner, Hans-Karsten, Dr. et al**
**Deichmannhaus am Hauptbahnhof**
**W-5000 Köln 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.5x/3.0.1)

## Description

Field of the Invention

This invention relates to imaging systems in which the imaged layer contains image areas having an index of refraction which is different from that of non-image areas. More particularly this invention relates to such systems wherein the refractive index image is a reflection hologram.

The present invention is an embodiment of the process for forming a light-stable hologram in a photopolymerizable layer on a substrate surface disclosed in EP 89 100 495.4 having the same priority and filing date.

Discussion of the Background and Prior Art

The term "image recording" is conventionally taken to mean a process which produces a spatial pattern of optical absorption in the recording medium. Photographic processes are well known examples of this type of process.

In a broader sense, however, the word "image" means a spatial variation of the optical properties of a sample in such a way as to cause a desired modification of a beam of light passing through the sample. Refractive index images in general and holograms in particular, which modulate the phase, rather than the amplitude, of the beam passing through them are usually referred to as phase holograms. Phase holographic image recording systems produce a spatial pattern of varying refractive index rather than optical absorption in the recording medium and, thus, can modulate a beam of light without absorbing it.

This type of refractive index image also includes a number of optical elements or devices which superficially bear little resemblance to absorption images. Examples are holographic lenses, gratings, mirrors, and optical waveguides.

Holography is a form of optical information storage. The general principles are described in a number of references, e.g., "Photography by Laser" by E. N. Leith and J. Upatnieks in SCIENTIFIC AMERICAN 212, No. 6,24-35 (June, 1965). In brief, the object to be photographed or imaged is illuminated with coherent light, e.g., from a laser, and a light sensitive recording medium, e.g., a photographic plate, is positioned so as to receive light reflected from the object. Each point on the object reflects light to the entire recording medium, and each point on the medium receives light from the entire object. This beam of reflected light is known as the object beam. At the same time, a portion of the coherent light is beamed by a mirror directly to the medium, bypassing the object. This beam is known as the reference beam. What is recorded on the recording medium is the interference pattern that results from the interaction of the reference beam and the object beam impinging on the medium. When the processed recording medium is subsequently illuminated and observed appropriately, the light from the illuminating source is diffracted by the hologram to reproduce the wave-front that originally reached the medium from the object, so that the hologram resembles a window through which the virtual image of the object is observed in full three-dimensional form, complete with parallax.

Holograms that are formed by allowing the reference and object beams to enter the recording medium from the same side are known as transmission holograms. Interaction of the object and reference beams in the recording medium forms fringes of material with varying refractive indices which are approximately normal to the plane of the recording medium. When the hologram is played back by viewing with transmitted light, these fringes refract the light to produce the viewed virtual image. Such transmission holograms may be produced by methods which are well known in the art such as disclosed in U.S. Patent 3,506,327; U.S. Patent 3,838 903 and U.S. Patent 3,894,787.

A diffraction grating is the simplest possible transmission hologram. It is the hologram of two coherent plane waves. It can be created by splitting a single laser beam and recombining the beams at the recording medium.

The interference pattern produced by two plane waves which are coherent and are not polarized perpendicular to each other is a set of uniformly spaced fringes with a sinusoidal intensity distribution. When incident on a recording medium they produce a set of uniformly spaced fringes which have a sinusoidal variation in refractive index, generally referred to as a grating, oriented parallel to the bisector of the angle between the two beams. If the two waves are incident at equal angles with respect to the surface of the recording medium and are both incident on the same side of the recording medium, the fringes are perpendicular to the surface of the medium and the grating is said to be unslanted. The hologram grating produced is said to be a transmission grating since light passing through it is diffracted. The grating is said to be thick if it is much thicker than the distance between the fringes, generally referred to as the grating

spacing.

A diffraction grating can be characterized by its diffraction efficiency, that is the percent of incident radiation which is diffracted, and by its thickness. A simple but useful theory for thick hologram gratings, generally known as the "coupled wave theory", has been developed by Kogelnik (H. Kogelnik, Coupled wave theory for thick hologram gratings, Bell Syt. Tech. J., 48, 2909-2947, 1969). This theory treats the relationship between diffraction efficiency, grating thickness, wavelength of incident radiation, and the angle of incident radiation. A useful discussion of this theory in regard to refractive index recording systems has been presented in Section II of an article by Tomlinson and Chandross (W. J. Tomlinson and E. A. Chandross, Organic photochemical refractive-index image recording systems, Adv. in Photochem., Vol. 12, J. N. Pitts, Jr., G. S. Hammond, and K. Gollnick, eds., Wiley-Interscience, New York, 1980, pp. 201-281).

Holograms formed by allowing the reference and object beams to enter the recording medium from opposite sides, so that they are traveling in approximately opposite directions are known as reflection holograms. Interaction of the object and reference beams in the recording medium forms fringes of material with varying refractive indices which are, approximately, planes parallel to the plane of the recording medium. When the hologram is played back these fringes act as mirrors reflecting incident light back to the viewer. Hence, the hologram is viewed in reflection rather than in transmission. Since the wavelength sensitivity of this type of hologram is very high, white light may be used for reconstruction.

Reflection holograms may be produced by an in-line or on-axis method wherein the beam of coherent radiation is projected through the recording medium onto an object therebehind. In this instance, the reflected object beam returns and intersects with the projected beam in the plane of the recording medium to form fringes substantially parallel to the plane of the medium. Reflection holograms also may be produced by an off-axis method wherein a reference beam is projected on one side of the recording medium and an object beam is projected on the reverse side of the medium. In this instance the object beam is formed by illuminating the object with coherent radiation which does not pass through the recording medium. Rather, the original beam of coherent radiation is split into two portions, one portion being projected on the medium and the other portion being manipulated to project on the object behind the medium. Reflection holograms produced by an off-axis process are disclosed in U.S. Patent 3,532,406.

A holographic mirror is the simplest possible reflection hologram. It is the hologram of two coherent plane waves intersecting in a recording medium from substantially opposite directions. It can be created by splitting a single laser beam and recombining the beams at the recording medium, or the unsplit laser became can be projected through the medium onto a plane mirror therebehind. As with transmission halograms, a set of uniformly spaced fringes with a sinusoidal intensity distribution is formed which are oriented parallel to the bisector of the obtuse angle between the two projected beams. If the obtuse angle is 180° and the projected beams are normal to the plane of the medium, the fringes will be parallel to the plane of the medium. If the obtuse angle is less than 180° of if both beams are not normal to the plane of the medium, reflective fringes will be formed which will be slanted at an acute angle relative to the plane of the medium. The holographic mirror can be characterized by its reflection efficiency, that is the percent of incident radiation which is reflected, and by the spectral bandwidth and character of the reflected radiation.

The substantially horizontal fringes which form reflection holograms are much more difficult to record than the perpendicular fringes which form transmission holograms for two reasons. The first reason is the need for higher resolution, i.e., the need for more fringes per unit length, and thus a smaller fringe spacing. Horizontal reflection holograms require about 3X to 6X more fringes per unit length than do transmission holograms. The second reason is the sensitivity of horizontal fringes to shrinkage of the recording medium. Any shrinkage of the recording medium during exposure will tend to wash out the fringes and, if severe, will prevent a hologram from being formed. This is in contrast to the transmission hologram case, where shrinkage has little or no effect if the fringes are perpendicular to the plane of the medium, and produces only relatively minor image distortion if the transmission fringes are slanted more than 45° from the plane of the medium.

A variety of materials have been used to record volume holograms. Among the more important are: silver halide emulsions, hardened dichromated gelatin, ferroelectric crystals, photopolymers, photochromics and photodichromics. Characteristics of these materials are given in Volume Holography and Volume Gratings, Academic Press, New York, 1981 Chapter 10, pp. 254-304 by L. Solymar and D. J. Cook.

Dichromated gelatin is the material most widely used for recording volume holograms. This material has become the popular choice because of its high diffraction efficiency and low noise characteristics. However, dichromated gelatin has poor shelf life and requires wet processing. Plates must be freshly prepared, or prehardened gelatin must be used. Wet processing means that an additional step is required in hologram preparation and may also cause the hologram to change due to swelling and then shrinkage of the gelatin during processing. The requirement that plates by freshly prepared each time a hologram is made plus the

problems associated with wet processing make reproducibly extremely difficult to achieve with dichromated gelatin.

While early holograms where prepared from silver halide or dichromated colloids which required several processing steps, photopolymerizable elements were introduced which require only a single process step. U.S. Patent 3,658,526, discloses preparation of stable, high-resolution holograms from solid, photopolymerizable layers by a single step-process wherein a permanent refractive index image is obtained by a single imagewise exposure of the photopolymerizable layer to actinic radiation bearing holographic information. The holographic image formed is not destroyed by subsequent uniform actinic exposure, but rather is fixed or enhanced.

In spite of their many advantages, however, the solid photopolymerizable layers proposed by Haugh had limited response to visible radiation and reflection holograms produced therefrom have been poor at best, with little or no reflection efficiency. Thus, there has been a need for an improved process and composition for the preparation of reflection holograms.

Tanaka, US. patent 4,173,474, discloses the preparation of holograms from photopolymerizable layers. The hologram is developed by sequentially treating the exposed photopolymerizable layer with a first solvent which is capable of swelling the layer and then with a second solvent which is miscible with the first solvent but has relatively weak swelling action.

## Summary of the Invention

This invention provides an improved process for forming reflection holograms of improved reflection efficiency and increment spectral bandwidth through use of certain storage stable, solid, photopolymerizable elements as the recording medium. In one embodiment, the invention provides an improved process for forming a reflection hologram wherein a reference beam of coherent actinic radiation and an object beam of the same coherent actinic radiation enter a layer of recording medium from opposite sides to create an interference pattern in the medium that forms the hologram, wherein the medium is a substantially solid, photopolymerizable layer consisting essentially of:

(a) a polymeric binder selected from the group consisting of polyvinyl acetate, polyvinyl butyral, polyvinyl acetal polyvinyl formal, interpolymers containing major segments thereof and mixtures thereof:

(b) an ethylenically unsaturated monomer selected from the group consisting of carbazole containing monomers and a liquid monomer containing one or more phenyl, phenoxy, naphthyl, naphthyloxy, heteroaromatic group containing up to three aromatic rings, chlorine and bromine and

(c) a photoinitiator system activatable by the actinic radiation.

In a preferred embodiment the liquid monomer is phenoxyethyl acrylate. In a still more preferred embodiment the ethylenically unsaturated monomer is a mixture of N-vinyl carbazole and phenoxyethyl acrylate.

It also has been found, surprisingly, that the reflection hologram formed in the recording medium is enhanced if the recording medium subsequently is treated with a liquid enhancing agent or is subsequently heated at a temperature of at least 50 ° C. Thus, in another embodiment, this invention also provides a process for forming and enhancing a reflection hologram in a substantially solid, photopolymerizable recording medium comprising:

(A) Projecting a reference beam of coherent actinic radiation on a first side of the recording medium which consists essentially of:

(1) a polymeric binder selected from the group consisting of polyvinyl acetate, polyvinyl butyral, polyvinyl acetal, polyvinyl formal, interpolymers containing major segments thereof and mixtures thereof;

(2) an ethylenically unsaturated monomer selected from the group consisting of carbazole containing monomers and a liquid monomer containing one or more phenyl, phenoxy, naphthyl, naphthyloxy, heteroaromatic group containing up to three aromatic rings, chlorine and bromine and

(3) a photoinitiator system activatable by the actinic radiation.

B) Projecting an object beam of the same coherent actinic radiation approximately in an opposite direction to the reference beam onto a second side of the photopolymerizable layer so as to intersect with the reference beam in a plane within the layer whereby a reflection hologram is formed;

C) Irradiating the imaged photopolymerizable layer with a uniform source of actinic radiation; and

D) either treating the irradiated reflection hologram with a liquid enhancing agent which is a swelling agent for the photopolymerized layer, or heating the irradiated reflection hologram at a temperature of at least 50 ° C for a period of time to enhance the reflectivity of the hologram.

Detailed Description of the Invention

In the process of this invention, reflection holograms are prepared using a substantially solid, photopolymerizable recording medium which comprises a transparent, dimensionally stable substrate having thereon a thin layer, typically between about 10 and 100 micrometers thick, of a unique, substantially solid, photopolymerizable composition.

In the instance of the "in-line" or "on-axis" mode of the process, a uniform, coherent beam of laser radiation, e.g., a collimated 488 nm argon-ion laser beam, is projected onto a first surface of the photopholymerizable layer typically at an angle of up to 70° from the normal to the plane of the layer. The collimated beam functions in part as a "reference beam" while a portion of the collimated beam which is transmitted through the layer and transparent substrate illuminates an object behind the layer. The portion of the transmitted laser radiation which is reflected by the object forms an "object beam" which projects back onto the rear second surface of the layer and interacts with the reference beam in the plane of the layer to form fringes which are oriented parallel to the bisector of the obtuse angle between the reference and object beams. The assembly of fringes in the plane of the layer forms a reflection hologram when viewed with radiation projected on the front surface of the layer. A potential difficulty with this mode of operation results when the media layer absorbs a substantial portion of the incident collimated beam so that the reflected object beam is too weak to form a satisfactory hologram. The unique formulations of this invention can be easily adjusted to minimize these potential problem.

In the instance of the "off-axis" mode of this process the potential difficulty is partially obviated by splitting the uniform, coherent beam of laser radiation. One of the split beams is projected onto the first front surface as a reference beam and the second split beam is manipulated to bypass the photopolymerizable layer and directly illuminate the object behind the layer. The reflected radiation forms an object beam which can be adjusted in intensity by simply adjusting the intensity ratio of the split radiation beams.

The object to be illuminated to form the object beam may be a real three dimensional object or it may itself be a reflection or transmission hologram. When a hologram is used as the object, a virtual image in reconstructed to form the object beam. In the instance when a reflection hologram is used as the object, it simply may be placed behind the photopolymerizable layer and reproduced by the in-line mode of operation. In the instance when a transmission hologram is used as the object, a manipulated split beam illuminates the hologram at the Bragg Angle to reconstruct the virtual image and form the object beam.

For the purpose of evaluating materials useful in the processes of this invention holographic mirrors are prepared and reflection efficiency, spectral bandwidth and wavelength of maximum reflection are determined. A film element is prepared comprising, in order: a 0.1 mm thick clear polyethylene terephthalate film support; a dried, coated photopolymerizable layer between about 15 and 35 micrometers thick; and a 0.023 mm thick polyethylene terephthalate cover sheet.

Coated film is cut into uniform sections, the cover sheet is removed, and the film then mounted by hand laminating the tacky coating directly to either the glass back of an aluminium front-surface mirror or to a glass plate. Typically, the film support is left in place on the laminate and serves to protect the layer during exposure and handling operations.

For coatings mounted on front surface mirrors, holographic mirrors are formed by actinic exposure under the same exposure conditions to a collimated 488 nm argon-ion laser beam, $TEM_{oo}$ mode, oriented perpendicular to the film plane and reflecting back on itself. After recording holographic mirrors, film samples are overall exposed to ultraviolet and visible light. The film support and coating are then removed from the front surface mirror and transmission spectra of the unprocessed holographic mirrors are recorded at 400-500 nm using a conventional spectrophotometer. Maximum reflection efficiency, wavelength, and bandwidth at half maximum (fwhm) are measured from the transmission spectra. The holographic mirrors are then thermally processed by heating to 80 or 150°C for 30 minutes in a convection oven, cooled to room temperature, and analyzed again by recording and measuring their transmission spectra.

Coatings mounted on glass plates are exposed to form holographic mirrors in the same manner as those mounted on front surface mirrors, except that each plate is tightly clamped to a front surface aluminium mirror which reflect the laser beam back onto itself. Coating samples with holographic mirrors are overall exposed as described above. Generally, the film support is then removed, leaving the coating on the glass plate. Unprocessed holographic mirrors are analyzed by recording and measuring their transmission spectra, after which they are thermally processed by heating to 150°C in a convection oven, cooled to room temperature, and analyzed again.

Reflection efficiencies using prior art solid formulations typically are less than 10% whereas reflection efficiencies of as high as 99% can be achieved using the processes of this invention.

The improved photopolymerizable compositions used in the processes of this invention are substantially solid and are typically used as a layer applied to a permanent substrate. The composition may be directly coated onto the substrate by any conventional method or may be laminated thereto as a storage stable, preformed element comprising the photopolymerizable layer releasably adhered to a temporary support film which is dimensionally stable and, preferably, transparent to actinic radiation, e.g., of polyethylene terephthalate. The other side of the supported photopholymerizable layer may have a temporary protective coversheet releasably adhered thereto, e.g., polyethylene, polypropylene, etc. Typically the coversheet has the weaker adherence to the photopolymerizable layer and the permanent substrate has the stronger adherence. Conventional intermediate layers or coatings may be used to facilitate the adhesive and/or release characteristics needed for the preformed element.

The photopolymerizable layer is a thermoplastic composition which upon exposure to actinic radiation forms crosslinks or polymers of higher molecular weight to change the refractive index and rheological character of the composition. Preferred photopolymerizable compositions are compositions wherein free radical addition polymerization and crosslinking of a compound containing one or more ethylenically unsaturated groups, usually in a terminal position, hardens and insolubilizes the composition. The sensitivity of the photopolymerizable composition is enhanced by the photoinitiating system which may contain a component which sensitizes the composition to practical radiation sources, e.g., visible light. Conventionally a binder is the most significant component of a substantially dry photopolymerizable film or layer in terms of what physical properties the film or laminate will have while being used in the invention. The binder serves as a containing medium for the monomer and photoinitiator prior to exposure, provide the base line refractive index, and after exposure contributes to the physical and refractive index characteristics needed for the reflection hologram or refractive index image formed. Cohesion, adhesion, flexibility, miscibility, tensil strength, in addition to index of refraction, are some of the many properties which determine if the binder is suitable for use in a refractive index medium.

While the photopolymerizable layer is a solid sheet of uniform thickness it is composed of at least three major components: a solid, solvent soluble, preformed, polymeric material; at least one ethylenically unsaturated monomer capable of addition polymerization to produce a polymeric material with a refractive index substantially different from that of the preformed polymeric material; and a photoinitiator system activatable by actinic radiation. Although the layer is a solid composition, components interdiffuse before, during and after imaging exposure until they are fixed or destroyed by a final uniform treatment, usually by a further uniform exposure to actinic radiation or by thermal treatment at elevated temperatures. Interdiffusion may be further promoted by incorporation into the composition of an otherwise unreactive plasticizer. Typically, the composition contains a liquid monomer, but it may contain solid monomer components, either individually or in combination with the liquid monomer, which are capable of interdiffusing in the solid composition and reacting to form a polymer or copolymer with a refractive index shifted from that of the preformed polymeric material.

Preformed polymeric materials useful in solid, photopolymerizable layers for forming high reflectivity reflection holograms are polyvinyl acetate, polyvinyl formal, polyvinyl acetal, polyvinyl butyral, and mixtures thereof. Also useful are interpolymers containing within their structure major segments or portions of the aforementioned polymers. By the use of these particular preformed polymeric materials it is possible to form and enhance reflection holograms as contrasted to previously used solid photopolymerizable layers.

Ethylenically unsaturated monomers useful in the practice of this invention are ethylenically unsaturated carbazole monomers, e.g., N-vinyl carbazole and/or a liquid, ethylenically unsaturated compound capable of addition polymerization and having a boiling point above 100 ° C. The monomer contains either a phenyl, phenoxy, naphthyl, naphthyloxy, heteroaromatic group containing up to three aromatic rings, chlorine or bromine. The monomer contains at least one such moiety and may contain two or more of the same or different moieties of the group, provided the monomer remains liquid. Contemplated as equivalent to the groups are substituted groups where the substitution may be lower alkyl, alkoxy, hydroxy, carboxy, carbonyl, amino, amide, imido or combinations thereof provided the monomer remains liquid and diffusable in the photopolymerizable layer. Suitable monomers which can be used as the sole monomer or in combination with liquid monomers of this type include but are not limited to styrene, 2-chlorostyrene, 2-bromostyrene, methoxystyrene, phenyl acrylate, ρ-chlorophenyl acrylate, 2-phenylethyl acrylate, 2-phenoxyethyl acrylate, 2-phenoxyethyl methacrylate, phenol ethoxylate monoacrylate, 2-(ρ-chlorophenoxy)ethyl acrylate, benzyl acrylate, 2-(1-naphthyloxy)ethyl acrylate, 2,2-di(ρ-hydroxy phenyl)-propane diacrylate or dimethacrylate, 2,2-di(p-hydroxyphenyl)-propane dimethacrylate, polyoxyethyl-2,2-di-(p-hydroxyphenyl)-propane dimethacrylate, di-(3-methacryloxy-2-hydroxypropyl) ether or bisphenol-A, di-(2-methacryloxyethyl) ether of bisphenol-A, di(3-acryloxy-2-hydroxypropyl) ether of bisphenol-A, di(2-acryloxyethyl) ether of bisphenol-A, ethyoxylated bisphenol-A diacrylate, di(3-methacryloxy-2-hydroxpropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of diphenolic acid, 1,4-benzenediol dimethacrylate 1,4-diisopropenyl benzene, 1,3,5-triisopropenyl benzene, hydroquinone methyl methacrylate, and 2-[B-(N-carbazoyl)-propionyloxy]ethyl acrylate.

Preferred liquid monomers for use in this invention are 2-phenoxyethyl acrylate, 2-phenoxyethyl methacrylate, phenol ethoxylate monoacrylate, 2-(ρ-chlorophenoxy)ethyl acrylate, ρ-chlorophenyl acrylate, phenyl acrylate, 2-phenylethyl acrylate, di(2-acryloxyethyl)ether of bisphenol-A, ethoxylated bisphenol-A diacrylate and 2-(1-naphthyloxy)ethyl acrylate.

Ethylenically unsaturated carbazole monomers having ethylenic substitution on the nitrogen atom of the carbazole moiety typically are solids. Suitable monomers of this type include N-vinyl carbazole and 3,6-dibromo-9-vinyl carbazole. Of these N-vinyl carbazole is preferred.

A particularly preferred ethylenically unsaturated monomer comprises N-vinyl carbazole used in combination with the above preferred liquid monomers and, in particular, with 2-phenoxyethyl acrylate, phenol ethoxylate monoacrylate, ethoxylated bisphenol-A diacrylate, or mixtures thereof.

While monomers useful in this invention are liquids, they may be used in admixture with one or more ethylenically unsaturated solid monomers such as the ethylenically unsaturated carbazole monomers disclosed in Journal of Polymer Science: Polymer Chemistry Edition. Vol. 18. pp. 9-18 (1979) by H. Kamogawa et al.; 2-naphthyl acrylate; pentachlorophenyl acrylate; 2,4,6-tribromophenyl acrylate; bisphenol-A diacrylate; 2-(2-naphthyloxy)ethyl acrylate: and N-phenyl maleimide.

In the embodiment of this invention where crosslinking is desirable, e.g., during thermal enhancement and curing, up to about 5 weight per cent of at least one multifunctional monomer containing two or more terminal ethylenically unsaturated groups typically is incorporated into the photopolymerizable layer. Suitable such multifunctional monomers are the acrylic adducts of bisphenol-A ethers identified above and acrylate and methacrylate esters such as: 1,5-pentanediol diacrylate, ethylene glycol diacrylate, 1,4-butanediol diacrylate, diethylene glycol diacrylate, hexamethylene glycol diacrylate, 1,3-propanediol diacrylate, decamethylene glycol diacrylate, decamethylene glycol dimethacrylate, 1, 4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, pentaerythritol tetraacrylate, triethylene glycol diacrylate, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate. pentaerythritol trimethacrylate, pentaerythritol tetramethacrylate, trimethylolpropane trimethacrylate, 1,5-pentanediol dimethacrylate, diallyl fumarate.

Preferred multifunctional monomers include a diacrylate or dimethacrylate of a bisphenol-A epoxy adduct such as di(2-acryloxyethyl) ether of bisphenol-A, ethoxylated bisphenol-A diacrylate, di(3-acryloxy-2-hydroxyphenyl) ether of bisphenol-A, and di(2-acryloxyethyl) ether of tetrabromo-bisphenol-A.

Photoinitiator systems useful in practicing this invention typically will contain a photoinitiator and a sensitizer which extends the spectral response into regions having special utility, e.g., the near U.V. region, and the visible and near infrared spectral regions where lasers emit.

Suitable free radical-generating addition polymerization initiators activatable by actinic light and thermally inactive at and below 185°C include and substituted or unsubstituted polynuclear quinones which are compounds having two intracyclic carbon atoms in a conjugated carbocyclic ring system, e.g., 9,10-anthraquinone, 1-chloroanthraquinone, 2-chloroanthraquinone, 2-methylanthraquinone, 2-ethylanthraquinone, 2-tert-butylanthraquinone, octamethylanthraquinone, 1,4-naphthoquinone 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2-3-diphenylanthraquinone, sodium salt of anthraquinone alpha-sulfonic acid, 3-chloro-2-methylanthraquinone, retenequinone, 7,8,9,10-tetrahydronaphthacenequinone, and 1,2,3,4-tetrahydrobenz(a)anthracene-7,12-dione. Other photoinitiators which are also useful, even though some may be thermally active at temperatures as low as 85°C, are described in U.S. Patent 2,760,863 and include vicinal ketaldonyl alcohols, such as benzoin, pivaloin, acyloin ethers, e.g., benzoin methyl and ethyl ethers, α-hydrocarbon-substituted aromatic acyloins, including α-methylbenzoin, α-allylbenzoin and α-phenylbenzoin.

Photoreducible dyes and reducing agents such as those disclosed in U.S. Patents: 2,850,445; 2,875,047; 3,097,096; 3,074,974; 3,097,097; 3,145,104; and 3,579,339; as well as dyes of the phenazine, oxazine, and quinone classes; Michler's ketone, benzophenone, 2,4,5-triphenylimidazolyl dimers with hydrogen donors, and mixtures thereof as described in U.S. Patents: 3,427,161; 3,479,185; 3,549,367;

4,311,783; 4,622,286; and 3,784,557 can be used as initiators. A useful discussion of dye sensitized photopolymerization can be found in "Dye Sensitized Photopolymerization" by D. F. Eaton in Adv. in Photochemistry. Vol. 13, D. H. Volman, G. S. Hammond, and K. Gollnick, eds., Wiley-Interscience, New York, 1986, pp. 427-487. Similarly, the cyclohexadienone compounds of U.S. Patent No. 4,341,860 are useful as initiators.

Preferred photoinitiators include CDM-HABI, i.e., 2-(o-chlorophenyl)-4,5-bis(m-methoxyphenyl)imidazole dimer; o-Cl-HABI, i.e., 1,1'-biimidazole, 2,2'-bis (o-chlorophenyl)-4,4'5,5'-tetraphenyl-; and TCTM-HABI. i.e., IH-imidazole, 2,5-bis(o-chlorophenyl)-4-[3,4-dimethoxyphenyl]-, dimer, each of which is typically used with a hydrogen donor, e.g., 2-mercaptobenzoxazole. Sensitizers useful with photoinitiators include methylene blue and those disclosed in U.S. Patents 3,554,753; 3,563,750; 3,563,751; 3,647.467; 3,652,275; 4,162,162; 4,268,667; 4,351,893; 4,454,218; 4,535,052; and 4,565,769. Particularly preferred sensitizers include the following: DBC, i.e., cyclopentanone; 2,5-bis-{[4-(diethylamino)-2-methylphenyl]methylene}; DEAW, i.e., cyclopentanone, 2,5-bis{[4-(diethylamino)-phenyl]methylene}; and dimethoxy-JDI, i.e., 1H-inden-1-one, 2,3-dihydro-5,6-dimethoxy-2-[(2,3,6,7-tetrahydro-1H,5H-benzo [i,j] quinolizin-9-yl)methylene]-. which have the following structures respectively:

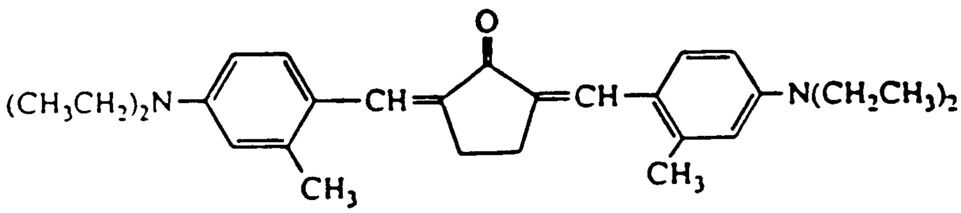

DBC

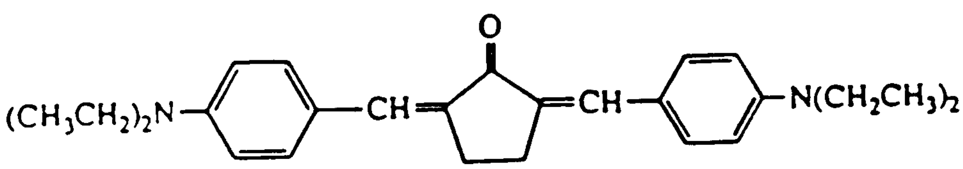

DEAV

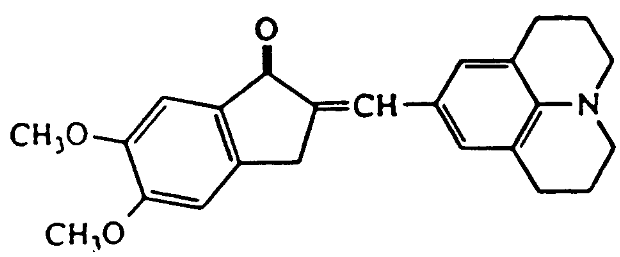

Dimethoxy-JDI

The solid photopolymerizable compositions of this invention may contain a plasticizer to enhance the refractive index modulation of the imaged composition. Plasticizers may be used in amounts varying from about 2% to about 25% by weight of the composition preferably 5 to about 15 wt.%. Suitable plasticizers include triethylene glycol, triethylene glycol diacetate, triethylene glycol dipropionate, triethylene glycol dicaprylate, triethylene glycol dimethyl ether, triethylene glycol bis(2-ethylhexanoate), tetraethylene glycol diheptanoate, poly(ethylene glycol), poly(ethylene glycol) methyl ether, isopropylnaphthalene, diisopropylnaphthalene, poly(propylene glycol), glyceryl tributyrate, diethyl adipate, diethyl sebacate, dibutyl suberate, tributyl phosphate, tris(2-ethylhexyl) phosphate, Brij® 30 [$C_{12}H_{25}(OCH_2CH_2)_4OH$], and Brij® 35 [$C_{12}H_{25}$-$(OCH_2CH_2)_{20}OH$]. Particularly preferred plasticizers for use in these systems are triethylene glycol

dicaprylate and tetraethylene glycol diheptanoate. Similarly, triethylene glycol dicaprylate and tetraethylene glycol diheptanoate are preferred for use with solid carbazole monomers in the absence of any second liquid monomers.

Other components in addition to those described above can be present in the photopolymerizable compositions in varying amounts. Such components include: optical brighteners, ultraviolet radiation absorbing material, thermal stabilizers, hydrogen donors and release agents.

Optical brighteners useful in the process of the invention include those disclosed in Held U.S. Patent 3,854,950. A preferred optical brightener is 7-(4′chloro-6′-diethylamino-1′,3′,5′-triazine-4′-yl) amino 3-phenyl coumarin. Ultraviolet radiation absorbing materials useful in the invention are also disclosed in Held U.S. Patent 3,854,950.

Useful thermal stabilizers include: hydroquinone, phenidone, p-methoxyphenol, alkyl and aryl-substituted hydroquinones and quinones, tert-butyl catechol, pyrogallol, copper resinate, naphthylamines, beta-naphthol, cuprous chloride, 2,6-di-tert-butyl p-cresol, phenothiazine, pyridine, nitrobenzene dinitrobenzene, p-toluquinone and chloranil. The dinitroso dimers described in Pazos U.S. Patent 4,168,982, are also useful. Normally a thermal polymerization inhibitor will be present to increase stability in the storage of the photopolymerizable composition.

Hydrogen donor compounds useful as chain transfer agents in the photopolymer compositions include: 2-mercaptobenzoxazole, 2-mercaptobenzothiazole, 4-methyl-4H-1,2,4,triazole-3-thiol, etc.; as well as various types of compounds, e.g., (a) ethers, (b) esters, (c) alcohols, (d) compounds containing allylic or benzylic hydrogen cumene, (e) acetals, (f) aldehydes, and (g) amides as disclosed in column 12, lines 18 to 58 of MacLachlan U.S. Patent 3,390,996. Suitable hydrogen donor compounds for use in systems containing both biimidazole type initiator and N-vinyl carbazole are 5-chloro-2-mercaptobenzothiazole; 2-mercaptobenzothiazole; 1H-1,2,4-triazole-3-thiol; 6-ethoxy-3-mercaptobenzothiazole; 4-methyl-4H-1,2,4-triazole-3-thiol; 1-dodecanethiol; and mixtures thereof. Compounds which have been found useful as release agents are described in Bauer U.S. Patent 4,326,010. A preferred release agent is polycaprolactone.

Amounts of ingredients in the photopolymerizable compositions will generally be within the following percentage ranges based on total weight of the photopolymerizable layer: monomer, 5-60%, preferably 15-50%; initiator 0.1-10%, preferably 1-5%: binder, 25-75%, preferably 45-65%; plasticizer, 0-25%, preferably 5-15%; other ingredients 0-5%, preferably 1-4%.

Reflection holograms formed using the unique solid photopolymerizable compositions of this invention have improved reflection efficiency, typically between about 15% to over 60%. Surprisingly, when such holograms are further treated with a particular class of liquids which swell the hologram, the reflection efficiency irreversibly jumps to 70% and above with no apparent detrimental effects. Concurrent with the reflection efficiency increase is an increase in the bandwidth as well.

The class of liquids which are particularly effective in enhancing reflection holograms are polar organic liquids which may swell the hologram, e.g., alcohols, ketones, esters, glycol alkyl esters etc. Use of one or more such enhancing agents is generally all that is required to effect an equilibrated image enhancement. The enhancing agent may be a single liquid or a mixture of such liquids of varying activity. Diluents, e.g., water, hydrocarbon solvents, can be present to decrease the concentration of the enhancing agent. Diluents are "inert solvents" which, when they are applied alone to the hologram surface, have substantially no effect on reflection efficiency. Diluted enhancing agents are used in the instance when limited equilibrated enhancement is desired at lower than maximum reflectance, or when use of the enhancing agent alone causes some dissolving of the hologram. Additional treatment of such limited equilibrated enhancement is possible with a more concentrated or more active enhancing agent.

Enhancing agent typically is applied after the reflection hologram has been fixed by uniform actinic exposure. The reflection hologram may be immersed in the enhancing agent or may be applied by other means.

The procedure for applying the swelling agent to the imaged holographic recording medium generally may be controlled to obtain a uniform enhancement of the reflection hologram and to prevent damage to the polymeric image, which is softened by the swelling action of the enhancing agent. Ideally, just sufficient enhancing agent is needed to uniformly wet the image surface without either flooding it or applying tangential or compressive forces. However, since the rate of enhancement of the diluted agents of this invention is slower and can be repeated, uniformity can be insured by multiple applications. Any method may be used to uniformly apply the swelling agent to the hologram provided the method does not entail abrasive or compressive forces which would distort or mar the image.

A satisfactory method of applying the enhancing agent is by lightly drawing across the image area the edge of a paint brush or other applicator such as a foraminous wick, soaked in enhancing agent. If the image area is small this procedure might be accomplished with a small brush or a felt-tip pen. If the image

area is large, a felt-edged squeegee of sufficient length might be used. In either case the enhancing agent is supplied uniformly from the applicator to the hologram and is absorbed into the hologram to increase its reflection efficiency. In place of felt, any foraminous material may be used such as paper, and woven and nonwoven fabrics. Similarly, the enhancing agent may be applied as a mist, e.g., using an airbrush; or carefully coated as a liquid film. Excess enhancing agent that may be present is removed from this hologram by known means. Normal evaporation or speeded evaporation by air impingement using air at ambient temperature or elevated temperature are useful in removing excess enhancing agent. The enhancing agent may also be removed by treating with diluent nonenhancing agent.

Enhancing agents useful in this invention include: glycol alkyl ethers, e.g., 2-methoxyethanol, 2-ethoxyethanol and 2-butoxyethanol; alcohols, e.g., methanol, ethanol, butanol, 1- or 2-propanol; ketones, e.g., acetone, methyl ethyl ketone, cyclohexanone, etc.; esters, e.g., ethyl acetate, etc.; as well as other enhancing agents.

Diluents that may be present with the aforementioned enhancing agent include: water; inert hydrocarbon solvent, e.g., Soltrol®50, a mixture of $C_{8-10}$ iso-paraffins with a boiling point range of 116-149° C, a product of Philips Petroleum; hexane; cyclohexane; heptane; 1,2-dichloroethane; trichlorotrifluoroethane; and the like.

Typically, maximum enhancement of the entire reflection hologram is desired, requiring full strength treatment of the hologram by a highly active agent for a duration to reach an increased equilibrated reflection efficiency. Surprisingly, the reflection efficiency remains at the equilibrated value even after the agent has been substantially removed. In those instances where immersion is not used or where isolated areas of the hologram are to be enhanced, controlled methods of application identified above may be used to prevent flooding of the hologram surface and retain the agent in the desired isolated area.

Reflection holograms formed using the unique solid photopolymerizable compositions of this invention may be thermally treated to enhance reflection efficiency up to about 100%. In this embodiment, a reflection hologram is first formed in the photopolymerizable layer of this invention and is then heated to a temperature above 50° C and preferably between 100 and 160° C for a commensurate time period to maximize enhancement. Thermal enhancement treatment may be carried out either before of after any actinic radiation fixing step. Typically it is carried out before any fixing step and may be used to concurrently fix the enhanced hologram by thermally hardening or polymerizing the photopolymerizable material in the hologram. After thermal enhancement is complete, the enhanced hologram may be fixed, if needed, by uniform irradiation with a source of actinic radiation. Both the rate of thermal enhancement and the rate of thermal hardening increase with increasing temperature.

In the practice of this embodiment of the invention, the reflection hologram once formed may be heated by any conventional method to enhance its reflection efficiency. The hologram may be heated in a single convection oven, irradiated with infrared or microwave radiation or contact heated on a hot shoe or in a lamination press. Whichever means is used, care is needed to prevent distortion or damage to the photopolymer layer containing the reflection hologram.

A particular useful application of thermal enhancement embodiment is in the preparation of "head-up" displays for use in windshields and other such glass laminate structures. In this instance, a glass sheet has applied thereto a polymeric reflection hologram of this invention. The reflection hologram may be formed directly in a photopolymerized layer previously applied to the glass sheet, or it may be preformed in a photopolymerizable element containing a temporary support and then laminated to a glass sheet. In the latter preformed mode of operation sufficient heat may be used during lamination to the glass sheet to thermally enhance the reflection hologram. After removal of the temporary support the laminated glass sheet may be used as a head-up display. More preferably, a glass sheet with the photopolymer reflection hologram thereon is placed in a lamination press along with a second mating glass sheet with a Butacite® polymer sheet there between so that the photopolymer hologram is in face to face contact with the Butacite® interleaf. Heat and pressure are applied to the glass-sandwich structure, e.g., about 150° C, whereby the reflection hologram is enhanced and fixed concurrently with forming a glass laminate. Surprisingly, a safety glass laminate is formed having therein a reflection hologram substantially free of distortion due to the lamination process. The safety glass laminate can be used as a "head-up" display. While glass typically is used in such displays, other transparent sheet material may also be used, e.g., quartz, polymethyl methacrylate, polycarbonate, polystyrene, and the like.

The advantages of the embodiments of this invention can be observed by reference to the following examples.

## GENERAL PROCEDURES

### Sample Preparation

Coating solutions without visible sensitizer, DEAW, were prepared under yellow or red light. After addition of DEAW, all operations on solutions and their resulting coatings were performed under red light only. To further protect them from actinic light, all solutions were prepared and stored in amber bottles. Solutions were prepared by adding components to the solvent and mixing with a mechanical stirrer until they completely dissolved. The solvent was a mixture of dichloromethane (90-95% by weight) and methanol (5%), ethanol (10%), or 2-propanol (10%) unless otherwise specified. Solution components were used as received from the manufacturer without purification, except for o-Cl-HABI and POEA which were chromatographed on aluminum oxide (activity-1) prior to use.

Solutions were coated onto a 100 micron (4-mil) clear film support of polyethylene terephthalate at a speed of 2 to 4 cm/sec (4 to 8 fpm) using a Talboy coater equipped with a 150-200 micron (6-8 mil) doctor knife, 3,7 m (12 ft) drier set at 40-50 °C, and a laminator station. A cover sheet 25 micron (1 mil) polyethylene terephthalate was laminated to the coatings after drying. Coating samples were stored in black polyethylene bags at room temperature until used.

### Sample Evaluation

Coated film was cut into 10,1 cm x 12,7 cm (4x5-inch) sections, the cover sheet was removed, and the film then mounted by hand laminating the tacky coating directly to either the glass back of an aluminum front-surface mirror or to a glass plate. The film support was left in place during exposure and initial handling operations.

Coatings mounted on front surface mirrors were evaluated by recording holographic mirrors and determining their reflection efficiency, bandwidth, and wavelength of maximum reflection. The holographic mirrors were formed by actinic exposure to a collimated 488 nm argon-ion laser beam, $TEM_{oo}$ mode, oriented perpendicular to the film plane and reflecting back on itself. The beam had a 2.5-3.0 cm diameter and an intensity of 10-54 $mW/cm^2$. Laser exposure times ranges from 5-10 seconds, corresponding to 200-270 $mJ/cm^2$ total exposure. After recording holographic mirrors, film samples were overall exposed to ultraviolet and visible light using a Douthitt type DCOP-X exposure unit equipped with a mercury arc photopolymer lamp (Theimer-Strahler #5027). The film support and coating were then removed from the front surface mirror and transmission spectra of the unprocessed holographic mirrors were recorded at 400-550 nm using a Hitachi Perkin-Elmer model 330 spectrophotometer. Maximum reflection efficiency, wavelength, and bandwidth at half maximum (fwhm) were measured from the transmission spectra. In example 28-53 the holographic mirrors were then thermally processed by heating to 80 to 150 °C for 30 minutes in a convection oven, cooled to room temperature, and analyzed again by recording and measuring their transmission spectra.

Coatings mounted on glass plates were exposed to form holographic mirrors, as described above, except each plate was tightly clamped to a front surface aluminum mirror having the plate orientated such that the beam, in order, passes through the glass, the coating, and the film support, and then reflects back on itself. Coating samples with holographic mirrors were overall exposed using the Douthitt exposure unit described above. Generally, the film support was then removed, leaving the coating on the glass plate. Unprocessed holographic mirrors were analyzed by recording and measuring their transmission spectra, after which they were thermally processed by heating to 150 °C in a convection oven, cooled to room temperature, and analyzed again. In some cases, the film support was left in place over the coating during thermal processing and evaluation.

Coating thicknesses were measured on photocured samples by scratching through the coating to the glass plate, then measuring the profile using a Sloan DEKTAK 3030 surface profile monitoring system.

## GLOSSARY OF CHEMICAL NAMES

| | |
|---|---|
| BHT | 2,6-Di-tert-4-methylphenol;CAS 128-37-0 |
| Butacite®B140C | Poly(vinylbutyral), plasticized with 4G7 |
| CAB 531-1 | Cellulose acetate butyrate, Eastman type 531-1, CAS 9004-36-8 |
| DEA | Diethyladipate |
| DEAW | Cyclopentanone, 2,5-bis{[4-(diethylamino)-phenyl]-methylene}CAS 38394-53-5 |
| EBPDA | Ethoxylated bisphenol-A diacrylate; CAS 24447-78-7 |

| | |
|---|---|
| 4G7 | Tetraethylene glycol diheptanoate; HATCOL 5147 |
| 2-HPA | 2-Hydroxypropyl acrylate; propyleneglycol monoacrylate |
| MMT | 4-Methyl-4H-1,2,4-triazole-3-thiol; CAS 24854-43-1 |
| NVC | N-Vinyl carbazole; 9-Vinyl carbazole; CAS 1484-13-5 |
| o-Cl-HABI | 2,2'-Bis(o-chlorophenyl)-4,4',5,5'-tetraphenyl-1,1'-biimidazole; CAS 1707-68-2 |
| POEA | 2-Phenoxyethyl acrylate; CAS 48145-04-6 |
| PVB | Poly(vinylbutyral), Aldrich, average M.W. 36,000; CAS 63148-65-2 |
| TDA | Triethylene glycol diacrylate; CAS 1680-21-3 |
| TDC | Triethylene glycol dicaprylate |
| TMPTA | Trimethylolpropane triacrylate: 2-ethyl-2-(hydroxymethyl)-1,3-propanediol triacrylate; CAS 15625-89-5 |
| Vinac® B-15 | Poly(vinylacetate), Air Products, M.W. 90,000; CAS 9003-20-7 |
| Vinac® B-100 | Poly(vinylacetate), Air Products, M.W. 500,000; CAS 9003-20-7 |

## CONTROL EXAMPLES A-B; EXAMPLES 1-2

Control Examples A and B disclosed in EP 89 100 495.4 with either NVC or POEA as monomer and CAB as binder either were inoperative or had poor reflection efficiency and spectral bandwidth. Useful coatings were achieved using poly(vinyl acetate) binder.

The formulations shown below were prepared and coated with a Talboy coater equipped with a 175 micron (7 mil) doctor knife. All quantities are in grams, unless otherwise indicated. The film in control example A was not imaged since it was opaque with crystals as coated. The film from Example 1 also formed crystals but slowly enough to allow imaging of the film. Plates were prepared and holographic mirror imaged as described above except that the 514 nm beam of an argon ion laser was used at a power of about 10 mW. Film thicknesses, reflection efficiencies, and spectral bandwidths are reported below.

| | Example Number | | | |
|---|---|---|---|---|
| | A | B | 1 | 2 |
| Vinac® B-15 | - | - | 14.16 | 14.25 |
| CAB 531-1 | 14.22 | 14.25 | - | - |
| NVC | 9.04 | - | 9.04 | - |
| POEA | - | 9.06 | - | 9.04 |
| o-Cl-HABI | 0.74 | 0.74 | 0.74 | 0.73 |
| MMT | 0.251 | 0.250 | 0.251 | 0.250 |
| DEAW | 0.012 | 0.012 | 0.012 | 0.012 |
| BHT | 0.001 | 0.001 | 0.001 | 0.001 |
| Methanol | 12.2 | 12.2 | 12.2 | 12.2 |
| Methylene Chloride | 110.3 | 109.9 | 110.1 | 109.8 |
| Film Thickness, micron - | - | 17.1 | 16.0 | 18.9 |
| Reflection Efficiency, % | - | 3 | 15 | 27 |
| Spectral Bandwidth, nm | - | 5 | 5 | 7 |

The holographic mirrors were then processed in a bath composed of 3% cyclohexanone in isopropanol. The mirrors were immersed in the bath for two minutes, air dried for about five minutes, immersed in the developer bath for another two minutes, and air dried overnight. After drying, % transmission spectra were obtained. The bandwidth for Example 1 could not be measured due to the low reflection efficiency and width of the transmission band. The film from Example B wrinkled during development and a reflection could not be detected. Data obtained is given below.

| | Example Number | | | |
|---|---|---|---|---|
| | A | B | 1 | 2 |
| Reflection Efficiency, % | - | - | 3 | 78 |
| Spectral Bandwidth, nm | - | - | - | 18 |

EXAMPLE 3

This example shows good performance using poly(vinylbutyral), particularly compositions combining NVC and POEA liquid monomer.

The following formulation was prepared:

| | |
|---|---|
| Butacite® B140C | 179.8 g |
| POEA | 54.9 g |
| NVC | 37.6 g |
| o-Cl-HABI | 2.5 g |
| MMT | 2.5 g |
| BHT | 0.025 g |
| DEAW | 0.509 g |
| Methanol | 554 g |
| Tetrahydrofuran | 554 g |

The formulation was hand coated onto 100 micron (4 mil) polyethylene terephthalate film through a 25 micron (1 mil) doctor knife. The film was air dried at room temperature before applying a 25 micron (1 mil) polyethylene terephthalate film as coversheet. Plates were prepared and holographic mirrors imaged as described above. Each plate was exposed for 90 seconds with the 488 nm beam with a power of about 30 mW. The plate and mirror combination were oriented at either normal to or 40° off normal to the incident laser beam. Exposures made at normal to the incident beam will be referred to as "0°" and those at 40° off normal will be referred to as "40°". The following results were obtained:

| Angle | Measured Reflection Efficiency |
|---|---|
| 40° | 13% |
| 40° | 12% |
| 0° | 18% |
| 0° | 20% |

EXAMPLES 4-6

A stock formulation was prepared using 75 g of Butacite B140C, 6.25 g o-Cl-HABI, 2.5 g MMT, 0.125 g DEAW, and 500 g 10% methanol/90% methylene chloride. From this stock formulation three separate film formulations were prepared using 117 g portions for each formulation and adding to each formulation a total of 8 g of monomer. Each formulation was coated as described above. Film samples were mounted on glass plates and holographic mirrors prepared as in Example 3. The plate and mirror combination was oriented normal to the incident laser beam. Results are shown below.

| Example Number | Monomer(s) | Reflection Efficiency |
|---|---|---|
| 4 | 100% POEA | 2% |
| 5 | 100% NVC | 4% |
| 6 | 40.6% NVC, 59.4% POEA | 15% |

EXAMPLES 7-11

These are useful compositions similar to the poly(vinylbutyral) Examples 3-6 and also show that good results can be obtained by including a liquid plasticizer.

The formulations listed below were coated as described above. All quantities are in grams, unless otherwise indicated. Plates were prepared as described above and holographic mirrors generated by splitting the 488 nm beam from an Argon ion laser and impinging the collimated coherent beams onto

opposite sides of the plate with the angle between them about 180°. All films were exposed for 90 seconds. Reflection efficiencies and film thicknesses are given below.

| | Example Number | | | | |
|---|---|---|---|---|---|
| | 7 | 8 | 9 | 10 | 11 |
| Polyvinyl Butyral, Aldrich | 10.6 | 10.6 | 10.6 | 13.1 | 10.6 |
| NVC | 5.20 | 5.19 | 5.19 | 5.20 | 6.99 |
| POEA | 2.08 | 2.08 | 2.08 | 2.08 | 2.79 |
| TDC | 2.51 | - | - | - | - |
| DEA | - | 2.67 | - | - | - |
| 4G7 | - | - | 2.56 | - | - |
| o-Cl-HABI | 0.643 | 0.642 | 0.642 | 0.643 | 0.643 |
| MMT | 0.209 | 0.209 | 0.209 | 0.209 | 0.209 |
| DEAW | 0.011 | 0.011 | 0.011 | 0.011 | 0.011 |
| BHT | 0.001 | 0.001 | 0.001 | 0.001 | 0.001 |
| Methanol | 10.4 | 10.4 | 10.4 | 10.4 | 10.4 |
| Methylene Chloride | 93.5 | 93.4 | 93.4 | 93.5 | 93.5 |
| Film Thickness, micron | 20.6 | 20.5 | 20.5 | 19.8 | 19.0 |
| Reflection Efficiency,% | 21 | 27 | 20 | 28 | 19 |

EXAMPLES 12 and 13

These are useful compositions with poly(vinylacetate) binder, combined with a mixture of NVC and POEA monomer and TDC plasticizer. The formulations listed below were coated and holographic mirrors imaged as described in Example 7 except that exposure times for both films were 60 seconds. Film thicknesses and reflection efficiencies are reported below.

| | Example Number | |
|---|---|---|
| | 12 | 13 |
| Vinac® B15 | 12.6 | 15.1 |
| NVC | 6.18 | 2.47 |
| POEA | 2.55 | 6.1 |
| TDC | 2.56 | - |
| o-Cl-HABI | 0.75 | 0.76 |
| MMT | 0.26 | 0.25 |
| DEAW | 0.012 | 0.012 |
| BHT | 0.0013 | 0.0016 |
| Methanol | 12.3 | 12.3 |
| Methylene Chloride | 110.2 | 110.2 |
| Film Thickness, micron | 18.6 | 18.6 |
| Reflection Efficiency, % | 22 | 22 |

EXAMPLES 14-20

Additional useful compositions prepared from poly(vinylacetate) showing the advantage of using NVC/POEA mixtures are shown below. The listed formulations were coated and holographic mirrors imaged as described in Example 7. Reflection efficiencies and film thicknesses are reported below.

| | Example Number | | | |
|---|---|---|---|---|
| | 14 | 15 | 16 | 17 |
| Vinac® B-15 | 12.5 | 12.5 | 12.5 | 12.5 |
| NVC | - | 2.53 | 3.51 | 1.54 |
| POEA | 7.85 | 5.30 | 4.23 | 6.24 |
| TDC | - | - | - | - |
| o-Cl-HABI | 0.617 | 0.617 | 0.617 | 0.617 |
| MMT | 0.209 | 0.209 | 0.209 | 0.209 |
| DEAW | 0.010 | 0.010 | 0.010 | 0.010 |
| BHT | 0.001 | 0.001 | 0.001 | 0.001 |
| Methanol | 10.2 | 10.2 | 10.2 | 10.2 |
| Methylene Chloride | 91.5 | 91.4 | 91.4 | 91.4 |
| Film Thickness, micron | - | 15.0 | 13.1 | 12.8 |
| Reflection Efficiency, % | 4 | 38 | 13 | 18 |

| | Example Number | | |
|---|---|---|---|
| | 18 | 19 | 20 |
| Vinac® B-15 | 14.0 | 12.5 | 14.0 |
| NVC | - | 1.51 | - |
| POEA | 6.23 | 5.45 | 4.23 |
| TDC | - | 1.02 | 1.10 |
| o-Cl-HABI | 0.617 | 0.617 | 0.617 |
| MMT | 0.209 | 0.209 | 0.209 |
| DEAW | 0.010 | 0.010 | 0.010 |
| BHT | 0.001 | 0.001 | 0.001 |
| Methanol | 10.2 | 10.2 | 10.2 |
| Methylene Chloride | 91.4 | 91.4 | 91.4 |
| Film Thickness, micron | 14.2 | 15.3 | 13.5 |
| Reflection Efficiency, % | 11 | 28 | 4 |

EXAMPLES 21-23

These examples illustrate useful results can be obtained independent of poly(vinylacetate) molecular weight. The listed formulations were coated and holographic mirrors imaged as in Examples 7. Reflection efficiencies and film thicknesses are reported below.

| | Example Number | | |
|---|---|---|---|
| | 21 | 22 | 23 |
| Polyvinyl Acetate, Low MW, Aldrich | 37.4 | - | - |
| Polyvinyl Acetate, Medium MW, Aldrich | - | 37.4 | - |
| Polyvinyl Acetate, High MW, Aldrich | - | - | 37.4 |
| NVC | 7.63 | 7.62 | 7.56 |
| POEA | 16.0 | 16.0 | 15.9 |
| o-Cl-HABI | 1.86 | 1.86 | 1.87 |
| MMT | 0.625 | 0.625 | 0.627 |
| DEAW | 0.031 | 0.030 | 0.033 |
| BHT | 0.004 | 0.003 | 0.003 |
| Methanol | 25.1 | 25.2 | 25.2 |
| Methylene Chloride | 241.2 | 227.1 | 226.7 |
| Film Thickness, micron | 21.9 | 22.5 | 19.0 |
| Reflection Efficiency, % | 49 | 49 | 49 |

## EXAMPLE 24

This examples shows a useful poly(vinylformal) composition. The formulation below was coated and a holographic mirror imaged as described in Example 7 except that a 30 second exposure was used.

| | |
|---|---|
| Vinac B15 | 37.4 |
| NVC | 7.57 |
| POEA | 15.9 |
| o-Cl-HABI | 1.87 |
| MMT | 0.626 |
| DEAW | 0.030 |
| BHT | 0.003 |
| Methanol | 25.1 |
| Methylene Chloride | 226.1 |
| Film Thickness, micron | 16.7 |
| Reflection Efficiency, % | 20 |

## EXAMPLE 25

This and Examples 26 and 27 show a substantial reflection efficiency increase from treating the holographic mirror with a swelling solvent, whereas the prior art control compositions do not.

The formulation below was coated through a 150 micrometer (6 mil) doctor knife applicator. Plates were prepared and holographic mirrors imaged as described in the general procedures. Film thickness and reflection efficiency are reported below.

| | |
|---|---|
| Vinac® B15 | 37.5 |
| NVC | 7.64 |
| POEA | 15.9 |
| o-Cl-HABI | 1.86 |
| MMT | 0.625 |
| DEAW | 0.035 |
| BHT | 0.004 |
| Methanol | 25.2 |
| Methylene Chloride | 226.7 |
| Film Thickness, micron | 16.9 |
| Reflection Efficiency, % | 44 |
| Spectral Bandwidth, nm | 6 |

After obtaining the above data the holographic mirror was processed by gently wiping over the mirror a cotton swab containing acetone. After air drying for about 30 minutes a % transmission spectrum was recorded. The reflection efficiency had increased to 62% and the spectral bandwidth had increased to 35 nm.

## EXAMPLE 26

The formulation shown below was coated with a 175 micron (7 mil) doctor knife applicator. Plates were prepared and holographic mirrors imaged as described in the general procedures. Film thickness, reflection efficiency and spectral bandwidth are listed below.

| | | |
|---|---|---|
| Vinac® B15 | 37.5 | |
| NVC | 7.55 | |
| POEA | 15.9 | |
| o-Cl-HABI | 1.83 | |
| MMT | 0.623 | |
| DEAW | 0.017 | |
| BHT | 0.004 | |
| Methanol | 25.1 | |
| Methylene Chloride | 225.8 | |
| Film Thickness, micron | 25.8 | |
| Reflection Efficiency, % | 48 | (average 8 mirrors - all imaged identically) |
| Spectral Bandwidth, nm | 6-7 | (average 8 mirrors - all imaged identically) |

The holographic mirrors were then processed in a bath composed of 800 ml water and 600 ml acetone. The mirrors were immersed in the bath for 30 seconds, then water washed for 30 seconds, and then air dried. After drying, % transmission spectra were obtained. Data obtained is given below.

| | | |
|---|---|---|
| Reflection Efficiency, % | 77 | (average 3 mirrors - all imaged and processed identically) |
| Spectral Bandwidth, nm | 22-28 | (average 3 mirrors - all imaged and processed identically) |

## EXAMPLE 27 AND CONTROL EXAMPLES C-E

The formulations below were coated through a 175 micron (7 mil) doctor knife applicator. Plates were prepared and used at a power of about 10 mW. Results are reported below.

| | Example Number | | | |
|---|---|---|---|---|
| | 27 | C | D | E |
| Vinac® B-15 | 14.2 | - | 14.2 | - |
| CAB 531-1 | - | 14.2 | - | 14.1 |
| TDA | - | - | 9.04 | 9.04 |
| NVC | 2.50 | 2.50 | - | - |
| POEA | 6.49 | 6.50 | - | - |
| o-Cl-HABI | 0.73 | 0.73 | 0.74 | 0.74 |
| MMT | 0. 249 | 0.249 | 0.260 | 0.260 |
| DEAW | 0.012 | 0.012 | 0.012 | 0.012 |
| BHT | 0.001 | 0.001 | 0.001 | 0.001 |
| Methanol | 12.2 | 12.2 | 12.3 | 12.3 |
| Methylene Chloride | 109.8 | 110.0 | 110.2 | 110.1 |
| Film Thickness, micron | 16.9 | 17.7 | 17,0 | 16.4 |
| Reflection Efficiency, % | 23 | 10 | 1 | 0 |
| Spectral Bandwidth, nm | 6 | 6 | - | - |

The holographic mirrors were then processed in a bath composed of 3% cyclohexanone in 2-propanol. The mirrors were immersed in the bath for two minutes, air dried for about five minutes, immersed in the developer bath for another two minutes, and air dried overnight. After drying, % transmission spectra were obtained. Data obtained is given below.

| | Example Number | | | |
|---|---|---|---|---|
| | 27 | C | D | E |
| Reflection Efficiency, % | 75 | 6 | - | - |
| Spectral Bandwidth, nm | 14 | - | - | - |

EXAMPLES 28-31

These are useful compositions containing Vinac® B-15, a low molecular weight poly(vinylacetate) binder and various crosslinking monomers. Reflection holograms recorded in these compositions can be thermally processed to obtain greater reflection efficiency and bandwidth.

Four formulations were prepared, each containing a crosslinking acrylate monomer, with or without POEA, as described below, and each containing 14.2 g Vinac® B-15 (56.96% by weight of total solids), 3.0 g NVC (12%), 1.0 g o-Cl-HABI (4.0%), 0.50 g MMT (2.0%), 0.0075 g DEAW (0.03%), 71.25 g dichloromethane, and 3.75 g methanol. The formulations were coated on polyethylene terephthalate film, mounted on the back of a front-surface mirror, exposed, and evaluated according to the general procedures given above. The reflection efficiency, bandwidth, and wavelength of maximum reflection are presented below.

| | Example Number | | | |
|---|---|---|---|---|
| | 28 | 29 | 30 | 31 |
| POEA, grams (wt%)<br>EBPDA, grams (wt%)<br>TDA, grams (wt%)<br>TMPTA, grams (wt%)<br>Thickness, microns | -<br>6.25 (25)<br>-<br>-<br>24.8 | 3.75 (15)<br>2.50 (10)<br>-<br>-<br>27.4 | 5.00 (20)<br>-<br>1.25 (5)<br>-<br>27.2 | 5.00 (20)<br>-<br>-<br>1.25 (5)<br>28.0 |
| Unprocessed mirrors | | | | |
| Reflection Efficiency, %<br>fwhm, nm<br>$\lambda_{max}$, nm | 67.5<br>5<br>476.5 | 61.0<br>5<br>478.5 | 46.0<br>5<br>476.5 | 47.0<br>5<br>477.0 |
| Thermally processed: 80 ° C, 30 minutes, mirrors on polyethylene terephthalate film | | | | |
| Reflection Efficiency, %<br>fwhm, nm<br>$\lambda_{max}$, nm | 91<br>11<br>472 | 91<br>27<br>466 | 93<br>23<br>465 | 92<br>27<br>467 |
| Thermally processed: 150 ° C, 30 minutes, mirrors on polyethylene terephthalate film | | | | |
| Reflection Efficiency, %<br>fwhm, nm<br>$\lambda_{max}$, nm | 84.0<br>31<br>453 | 99.8<br>25<br>447 | 99.6<br>25<br>447 | 99.9<br>26<br>449 |

## EXAMPLES 32-35

These are useful compositions containing a low molecular weight poly(vinylacetate) binder, TMPTA crosslinking monomer, and varied amounts of POEA and NVC. Reflection holograms recorded in these compositions can be thermally processed to obtain greater reflection efficiency and bandwidth.

Four formulations were prepared, each containing TMPTA and POEA with or without NVC, as described in the following table, and each containing 28.48 g Vinac® B-15 (56.96% by weight of total solids), 2.0 g o-Cl-HABI (4.0%), 1.0 g MMT (2.0%), 0.015 g DEAW (0.03%). 0.005 g BHT (0.01%), 7.5 g methanol, and 142.5 g dichloromethane. The formulations were coated on film support, mounted on glass plates, exposed, and evaluated according to the general procedures given above. The reflection efficiency, bandwidth, and wavelength of maximum reflection are presented below.

## EXAMPLE 36

This is a useful composition containing a low molecular weight poly(vinylacetate) binder, TMPTA crosslinking monomer, and 4G7 plasticizer. Reflection holograms recorded in this composition can be thermally processed to obtain greater reflection efficiency and bandwidth.

A formulation was prepared containing POEA, TMPTA, NVC, and 4G7, as described below, and containing 14.24 g Vinac® B-15 (56.06% by weight of total solids), 1.0 g o-Cl-HABI (4.0%), 0.5 g MMT (2.0%), 0.0075 g DEAW (0.03%), 0.0025 g BHT (0.01%), 3.75 g methanol, and 71.25 g dichloromethane. The formulation was coated and evaluated as in Examples 32-35. The reflection efficiency, bandwidth, and wavelength of maximum reflection are presented below.

| | Example Number | | | | |
|---|---|---|---|---|---|
| | 32 | 33 | 34 | 35 | 36 |
| TMPTA, grams (wt%) | 2.5 (5) | 2.5 (5) | 2.5 (5) | 2.5 (5) | 1.25 (5) |
| POEA, grams (wt%) | 16.0 (32) | 13.0 (26) | 10.0 (20) | 8.0 (16) | 3.75 (15) |
| NVC, grams (wt%) | - | 3.0 (6) | 6.0 (12) | 8.0 (16) | 3.0 (12) |
| 4G7, grams (wt%) | - | - | - | - | 1.25 (5) |
| Thickness, microns | 22.3 | 21.6 | 24.2 | 24.5 | 22.4 |
| Unprocessed mirrors | | | | | |
| Reflection Efficiency, % | 32 | 51 | 64 | 66 | 58 |
| fwhm, nm | 6 | 5 | 5 | 5 | 6 |
| $\lambda_{max}$, nm | 476 | 477 | 477 | 478 | 478 |
| Thermally processed: 150 ° C, 90 minutes, mirrors on film support | | | | | |
| Reflection Efficiency, % | 56 | 89 | 99.9 | 99.8 | 99.4 |
| fwhm, nm | 22 | 32 | 30 | 30 | 30 |
| $\lambda_{max}$, nm | 464 | 458 | 447 | 437 | 437 |
| Thermally processed: 150 ° C, 90 minutes, mirrors on film support | | | | | |
| Reflection Efficiency, % | 56 | 80 | 99.9 | 99.2 | 84 |
| fwhm, nm | 16 | 25 | 30 | 42 | 35 |
| $\lambda_{max}$, nm | 467 | 471 | 470 | 476 | 462 |

EXAMPLE 37

This is a useful composition containing a low molecular weight poly(vinylacetate) binder, but no crosslinking monomer. Reflection holograms recorded in this composition can be thermally processed, without degradation, at temperatures of about 80 ° C or less, to obtain greater reflection efficiency and bandwidth.

A formulation was prepared containing POEA and NVC, as described below, and containing 284.8 g Vinac® B-15 (56.96% by weight of total solids), 20.0 g o-Cl-HABI (4.0%), 10.0 g MMT (2.0%), 0.15 g DEAW (0.03%), 0.05 g BHT (0.01%), 75 g methanol, and 1,425 g dichloromethane. The formulation was coated and evaluated as described in Examples 28 and 32, except an extrusion-die coating bar attached to the Talboy coater was used instead of a doctor knife. The reflection efficiency, bandwidth, and wavelength of maximum reflection are presented below.

Examples 38-41

These are useful compositions containing a low molecular weight poly(vinylacetate) binder and varied amounts of TMPTA crosslinking monomer. Reflection holograms recorded in these compositions can be thermally processed to obtain greater reflection efficiency and bandwidth.

Four formulations were prepared, each containing TMPTA, POEA, and NVC, as described below, and each containing 289.5 g Vinac® B-15 (56.96 by weight of total solids), 2.0 g o-Cl-HABI (4.0%), 1.0 g MMT (2.0%), 0.015 g DEAW (0.03%), 0.005 g BHT (0.01%), 7.5 g methanol, and 142.5 g dichloromethane. The formulations were coated and evaluated as described in Example 32. The reflection efficiency, bandwidth, and wavelength of maximum reflection are presented below.

| | Example Number | | | | |
|---|---|---|---|---|---|
| | 37 | 38 | 39 | 40 | 41 |
| TMPTA, grams (wt%) | - | 0.5 (1) | 1.0 (2) | 3.5 (7) | 4.5 (9) |
| POEA, grams (wt%) | 125 (25) | 12.0 (24) | 11.5 (23) | 9.0 (18) | 8.0 (16) |
| NVC, grams (wt%) | 60 (12) | 6.0 (12) | 6.0 (12) | 6.0 (12) | 6.0 (12) |
| Thickness, microns | 26.1 | 20.6 | 27.0 | 26.7 | 23.2 |
| Unprocessed mirrors | | | | | |
| Reflection Efficiency, % | 57 | 67 | 72 | 50 | 53 |
| fwhm, nm | 5 | 5 | 5 | 5 | 5 |
| $\lambda_{max}$, nm | 476 | 478 | 478 | 477 | 477 |
| Thermally processed: 80°C, 30 minutes, mirrors on film support | | | | | |
| Reflection Efficiency, % | 62 | - | - | - | - |
| fwhm, nm | 40 | - | - | - | - |
| $\lambda_{max}$, nm | 464 | - | - | - | - |
| Thermally processed: 150°C, 90 minutes, mirrors on glass, film support removed | | | | | |
| Reflection Efficiency, % | 0[a] | 0[a] | 99.9 | 99.4 | 98.7 |
| fwhm, nm | - | - | 33 | 27 | 22 |
| $\lambda_{max}$, nm | - | - | 448 | 444 | 443 |

| Thermally processed: 150°C, 90 minutes, mirrors between glass and film support | | | | | |
|---|---|---|---|---|---|
| Reflection Efficiency, % | 0[a] | 99.9 | 99.9 | 99.6 | 99.8 |
| fwhm, nm | - | 37 | 37 | 31 | 25 |
| $\lambda_{max}$, nm | - | 469 | 469 | 472 | 472 |

[a] Coating hazy, hologram destroyed or very weak.

EXAMPLES 42-43

These are examples of a low molecular weight poly(vinylacetate) based compositions for recording reflection holograms and use of these compositions to produce automobile windshield safety glass with a reflection hologram internally mounted (as might be used for head-up displays).

Two formulations were prepared, each containing Vinac B-15, TMPTA, POEA, and NVC, as described below, and each containing 2.0 g o-Cl-HABI (4.0%), 1.0 g MMT (2.0%), 0.015 g DEAW (0.03%), 0.005 g BHT (0.01%), 7.5 g methanol, and 142.5 dichloromethane. The formulations were coated on polyethylene terephthalate film support mounted on glass plates and exposed as described in the general procedures.

Unprocessed holographic mirrors on glass, film support removed, were analyzed by recording and measuring their transmission spectra; results are given below. A sheet of 750 micron (30 mil) Butacite® was then placed over each holographic mirror and a second piece of glass placed on the opposite side of the Butacite®, thus forming glass-hologram-Butacite®-glass composite structures which were clamped tightly together and heated to 150°C under vacuum for 60 minutes. The (safety) glass composite structures were then removed from the vacuum oven, allowed to cool to room temperature, and analyzed by recording and measuring their transmission spectra. Results are presented below.

EXAMPLE 44

This is an example of a low molecular weight poly(vinylacetate) based composition containing 2-HPA, and its use to produce safety glass with an internally mounted reflection hologram.

A formulation was prepared containing Vinac® B-15, TMPTA, POEA, NVC, and 2-HPA, as described below, and containing 1.0 g o-Cl-HABI (4.0%), 0,5 g MMT (2.0%), 0.0075 g DEAW (0.03%), 0.0025 g BHT (0.01%), 3.75 g methanol, and 71.25 g dichloromethane. The formulation was coated and evaluated as in Example 42. Results are presented below.

EXAMPLE 45

This is a useful composition containing Vinac® B-100, a high molecular weight poly(vinylacetate) binder, and TMPTA crosslinking monomer. Reflection holograms recorded in this composition can be thermally processed to obtain greater reflection efficiency and bandwidth. This composition is also useful for producing safety glass with internally mounted reflection holograms.

A formulation was prepared containing Vinac® B-100, TMPTA, POEA, NVC, and 2-HPA, as described below, and containing 0.75 g o-Cl-HABI (3.0%), 0.25 g MMT (1.0%), 0.010 g DEAW (0.04%), 0.0025 g BHT (0.01%), 3.75 g methanol, and 71.25 g dichloromethane. The formulation was coated and evaluated as in Example 42, except exposure was with a 514 nm argon ion laser beam, the holographic mirror was thermally processed before making the safety glass composite, and a longer heating cycle was used in making the safety glass composite, as shown in the table below.

| | Example Number | | | |
|---|---|---|---|---|
| | 42 | 43 | 44 | 45 |
| Vinac® B-15, grams (wt%) | 28.48 (57) | 28.48 (57) | 14.24 (57) | - |
| Vinac® B-100, grams (wt%) | - | - | - | 14.73 (59) |
| TMPTA, grams (wt%) | 2.50 (5) | 4.50 (9) | 1.25 (5) | 1.75 (7) |
| POEA, grams (wt%) | 10.00 (20) | 8.00 (16) | 3.75 (15) | 3.25 (13) |
| NVC, grams (wt%) | 6.00 (12) | 6.00 (12) | 3,00 (12) | 3.00 (12) |
| 2-HPA, grams (wt%) | - | - | 1.25 (5) | 1.25 (5) |
| Thickness, microns | 24.2 | 23.2 | 21.5 | 22.4 |
| Unprocessed mirrors | | | | |
| Reflection Efficiency, % | 65 | 57 | 50 | 32 |
| fwhm, nm | 4 | 4 | 4 | 5 |
| $\lambda_{max}$, nm | 477 | 476 | 477 | 503 |
| Thermally processed: 150 ° C, 60 minutes, mirrors between glass and Butacite® | | | | |
| Reflection Efficiency, % | 84 | 80 | 85 | - |
| fwhm, nm | 50 | 33 | 55 | - |
| $\lambda_{max}$, nm | 498 | 503 | 510 | - |
| Thermally processed: 100 ° C, 30 minutes, then 150 ° C, 60 min., mirrors on glass | | | | |
| Reflection Efficiency, % | - | - | - | 73 |
| fwhm, nm | - | - | - | 20 |
| $\lambda_{max}$, nm | - | - | - | 493 |
| (Process continued) then 150 ° C, 90 min., mirrors between glass and Butacite® | | | | |
| Reflection Efficiency, % | - | - | - | 72 |
| fwhm, nm | - | - | - | 15 |
| $\lambda_{max}$, nm | - | - | - | 562 |

EXAMPLES 46-47

These are useful compositions containing high molecular weight poly(vinylacetate) binder with and without a crosslinking monomer. Reflection holograms recorded in these compositions can be thermally processed to obtain greater reflection efficiency and bandwidth.

Two formulations were prepared as listed below. The formulations were coated as in the general procedures given above, except an extrusion-die coating bar was used rather than a doctor knife, and the drier was set at 50-60 ° C. Coatings were mounted on glass plates, exposed and evaluated according to the general procedure, except total laser exposure for each mirror was 300 mJ/cm$^2$. Results are presented below.

| | Example Number | |
|---|---|---|
| | 46 | 47 |
| Vinac® B-100, grams (wt%) | 374.75 (59.96) | 365.00 (56.96) |
| POEA, grams (wt%) | 93.75 (15.0) | 156.25 (25.0) |
| NVC, grams (wt%) | 68.75 (11.0) | 75.00 (12.0) |
| TMPTA, grams (wt%) | 31.25 (5.0) | - |
| 2-HPA, grams (wt%) | 25.00 (4.0) | - |
| o-Cl-HABI, grams (wt%) | 18.75 (3.0) | 25.00 (4.0) |
| MMT, grams (wt%) | 12.50 (2.0) | 12.50 (2.0) |
| DEAW, grams (wt%) | 0.188 (0.03) | 0.188 (0.03) |
| BHT, grams (wt%) | 0.063 (0.01) | 0.063 (0.01) |
| Methanol, grams | 93.8 | 93.8 |
| Dichloromethane, grams | 1781.2 | 1781.2 |
| Thickness, microns | 14.4 | 17.4 |
| Unprocessed mirrors | | |
| Reflection Efficiency,% | 28 | 53 |
| fwhm, nm | 5 | 5 |
| $\lambda_{max}$, nm | 479 | 479 |
| Thermally processed: 100 ° C, 30 minutes, mirrors between glass and film support | | |
| Reflection Efficiency,% | 75 | 99 |
| fwhm, nm | 8 | 13 |
| $\lambda_{max}$, nm | 479 | 479 |

EXAMPLE 48

This is a useful composition containing poly(vinylbutyral) binder and TDC plasticizer, but no crosslinking monomer. Reflection holograms recorded in this composition can be thermally processed, without degradation, at temperatures of about 80 ° C or less to obtain greater reflection efficiency and bandwidth.

A formulation was prepared containing POEA, NVC, and TDC, as described below and containing 25.4 g PVB (50.93%), 1.0 g o-Cl-HABI (2.0%), 1.0 g MMT (2.0), 0.030 g BHT (0.01%), 20.0 g 2-propanol, and 180 g dichloromethane. The formulation was coated on film support mounted on the back of a front-surface mirror, exposed, and evaluated according to the general procedures given above. Results are presented below.

EXAMPLES 49-51

These are useful compositions containing poly(vinylbutyral) binder and TMPTA crosslinking monomer. Reflection holograms recorded in these compositions can be thermally processed to obtain greater reflection efficiency and bandwidth.

Three formulations were prepared, each containing TMPTA, POEA, and NVC, as described below, and each containing 21.6 g PVB (53.96%), 1.6 g o-Cl-HABI (4.0%), 0.80 g MMT (2.0%), 0.012 g DEAW (0.03%), 0.0040 g BHT (0.01%), 16.0 g ethanol, and 144.0 g dichloromethane. The formulations were coated, exposed, and evaluated as in Example 48. Results are presented below.

EXAMPLE 52

This is a useful composition containing poly(vinylbutyral) binder, TMPTA crosslinking monomer, and 4G7 plasticizer. Reflection holograms recorded in this composition can be thermally processed to obtain greater reflection efficiency and bandwidth.

A formulation was prepared containing TMPTA, POEA, NVC, and 4G7, as described below and containing 17.96 g PVB (53.96), 1.33 g o-Cl-HABI (4.0%), 0.67 g MMT (2.0%), 0.010 g DEAW (0.03%), 0.0033 g BHT (0.01%), 13.3 g ethanol, and 119.8 g dichloromethane. The formulation was coated, exposed, and evaluated as in Example 48. Results are presented below.

| | Example Number | | | | |
|---|---|---|---|---|---|
| | 48 | 49 | 50 | 51 | 52 |
| TMPTA, grams (wt%) | - | 2.0 (5) | 2.0 (5) | 2.0 (5) | 1.67 (5) |
| POEA, grams (wt%) | 5.0 (10) | 4.0 (10) | 10.0 (25) | 14.0 (35) | 3.3 (10) |
| NVC, grams (wt%) | 12.5 (25) | 10.0 (25) | 4.0 (10) | - | 4.7 (15) |
| 4G7, grams (wt%) | - | - | - | - | 3.3 (10) |
| Thickness, microns | 24.5 | 23.9 | 26.1 | 24.1 | 26.7 |
| Unprocessed mirrors | | | | | |
| Reflection Efficiency, % | 49 | 49 | 48 | 20 | 43 |
| fwhm, nm | 6 | 4 | 5 | 5 | 4 |
| $\lambda_{max}$, nm | 474 | 478 | 476 | 477 | 477 |
| Thermally processed: 45°C, 12 hours, mirrors on film support | | | | | |
| Reflection Efficiency, % | 63 | 54 | 51 | 19 | 53 |
| fwhm, nm | 8 | 4 | 5 | 8 | 5 |
| $\lambda_{max}$, nm | 455 | 476 | 474 | 472 | 470 |
| Thermally processed: 45°C, 12 hours, then 80°C, 30 minutes, mirrors on film support | | | | | |
| Reflection Efficiency, % | 77 | 63 | 55 | 26 | 63 |
| fwhm, nm | 27 | 7 | 7 | 8 | 5 |
| $\lambda_{max}$, nm | 448 | 473 | 472 | 470 | 468 |

| Thermally processed: 150°C, 30 minutes, mirrors on film support | | | | | |
|---|---|---|---|---|---|
| Reflection Efficiency, % | 0[a] | 75 | 90 | 58 | 82 |
| fwhm, nm | - | 11 | 9 | 8 | 17 |
| $\lambda_{max}$, nm | - | 424 | 447 | 457 | 440 |

[a] Coating hazy/cloudy, hologram destroyed.

EXAMPLE 53

This is a useful composition coated on aluminized polyethylene terephthalate film.

A formulation identical to Example 34 was prepared and coated on 100 micron (4-mil) aluminized polyethylene terephthalate film using a 150 micron (6-mil) doctor knife. The drier temperature was 40-50 ° C. After drying, a cover sheet of silicon release polyethylene terephthalate film was laminated to the coating. A 10,1 cm x 12,7 cm (4x5-inch) section of coating was stripped of its cover sheet, mounted on a glass plate, and then exposed and evaluated according to the general procedure described above, except a front surface mirror was not clamped to the plate since the aluminized polyethylene terephthalate film served to reflect the incident radiation. After exposure, the aluminized polyethylene terephthalate film was removed leaving the holographic mirrors mounted on glass. Results before and after thermal processing follow:

| | Unprocessed Mirror | Processed:150 ° C, 90 min., on glass |
|---|---|---|
| Reflection Efficiency, % | 54 | 82 |
| fwhm, nm | 4 | 30 |
| $\lambda_{max}$, nm | 477 | 444 |

## Claims

1. A process for forming a reflection hologram wherein a reference beam of coherent actinic radiation and an object beam of the same coherent actinic radiation enter a layer of recording medium from opposite sides to create an interference pattern in the medium that forms the hologram, characterized in that the medium is a substantially solid, photopolymerizable layer consisting essentially of:
   (a) a polymeric binder selected from the group consisting of polyvinyl acetate, polyvinyl butyral, polyvinyl acetal, polyvinyl formal, interpolymers containing major segments thereof, and mixtures thereof;
   (b) an ethylenically unsaturated monomer selected from the group consisting of carbazole containing monomers and a liquid monomer containing one or more phenyl, phenoxy, naphthyl, naphthyloxy, heteroaromatic group containing up to three aromatic rings, chlorine and bromine and
   (c) a photoinitiator system activatable by the actinic radiation.

2. The process of claim 1 wherein the liquid monomer is selected from the group consisting of phenoxyethyl acrylate, phenol ethoxylate monoacrylate, the di(2-acryloxyethyl) ether of bisphenol-A, ethoxylated bisphenol-A diacrylate, 2-(1-naphthyloxy) ethyl acrylate, and mixtures thereof.

3. The process of claim 2 wherein the ethylenically unsaturated monomer is a mixture of a solid monomer selected from the group consisting of N-vinyl carbazole, 3,6-dibromo-9-vinyl carbazole, 2,4,6-tribromophenyl acrylate or methacrylate, pentachlorophenyl acrylate or methacrylate, 2-naphthyl acrylate or methacrylate, 2-(2-naphthyloxy)ethyl acrylate or methacrylate, the di-(2-acryloxyethyl)ether of tetrabromo-bisphenol-A and mixtures thereof; and a liquid monomer selected from the group consisting of phenoxyethyl acrylate, phenol ethoxylate acrylate, the di(2-acryloxyethyl ether) of bisphenol-A, ethoxylated bisphenol-A diacrylate, 2-(1-naphthyloxy)ethyl acrylate, and mixtures thereof.

**4.** The process of claim 1 in which a plasticizer is also present, which plasticizer is selected from the group consisting of tris(2-ethylhexyl)phosphate, glyceryl tributyrate, and a compound having the general formula:

$$R_1\overset{O}{\overset{\|}{C}}(OCH_2CH_2)_xO\overset{O}{\overset{\|}{C}}R_2;$$

$$R_1O\overset{O}{\overset{\|}{C}}(CH_2)_y\overset{O}{\overset{\|}{C}}OR_2;\ \text{or}$$

$$R_3(OCH_2CHR_4)_zOH$$

wherein $R_1$ and $R_2$ each is an alkyl group of 1 to 10 carbon atoms, $R_3$ is H or an alkyl group of 8 to 16 carbon atoms. $R_4$ is H or $CH_3$, x is 1-4, y is 2-20, and z is 1-20.

**5.** The process of claim 4 wherein the plasticizer is selected from the group consisting of triethylene glycol dicaprylate, triethylene glycol bis(2-ethylhexanoate), diethyl adipate, dibutyl adipate, tetraethylene glycol diheptanoate, dibutyl suberate, diethyl sebacate, tris(2-ethylhexyl)phosphate, and glyceryl tributyrate.

**6.** The process of claim 4 in which said plasticizer is substituted for at least a portion of the liquid ethylenically unsaturated monomer.

**7.** The process of claim 1 wherein the solid photopolymerizable layer contains an added crosslinking monomer containing two or more terminal ethylenically unsaturated groups.

**8.** The process of claim 7 wherein the crosslinking monomer is diacrylate or dimethacrylate of a bisphenol-A epoxy adduct.

**9.** A process for forming and enhancing a reflection hologram in a substantially solid photopolymerizable recording medium the process comprising:

A. Projecting a reference beam of coherent actinic radiation on a first side of the recording medium which consists essentially of:

(1) a polymeric binder selected from the group consisting of polyvinyl acetate, polyvinyl butyral, polyvinyl acetal, polyvinyl formal, interpolymers containing major segments thereof and mixtures thereof:

(2) an ethylenically unsaturated monomer selected from the group consisting of carbazole containing monomers and a liquid monomer containing one or more phenyl, phenoxy, naphthyl, naphthyloxy, heteroaromatic group containing up to three aromatic rings, chlorine and bromine and

(3) a photoinitiator system activatable by the actinic radiation;

B. Projecting an object beam of the same coherent actinic radiation approximately in an opposite direction to the reference beam onto a second side of the photopolymerizable layer so as to intersect with the reference beam in a plane within the layer whereby a reflection hologram is formed;

C. Irradiating the imaged photopolymerizable layer with uniform source of actinic radiation; and

D. either treating the irradiated reflection hologram with a liquid enhancing agent which is a swelling agent for the photopolymerized layer, or heating the irradiated reflection hologram at a temperature of at least 50 ° C for a period of time to enhance the reflectivity of the hologram.

**10.** A process of claim 9 wherein the liquid enhancing agent contains a polar organic liquid selected from the group consisting of an alcohol, a ketone, an aldehyde, a glycol alkyl ether, an ester, a liquid monomer and mixtures thereof.

**11.** The process of claim 10 wherein the liquid enhancing agent is selected from the group consisting of 1-propanol, methanol, ethanol, 2-propanol, acetone, methyl ethyl ketone, cyclohexanone, benzaldehyde, ethyl acetate, butyl benzoate, phenoxyethyl acrylate, phenol ethoxylate acrylate, ethoxylated bisphenol-A diacrylate, and mixtures thereof.

**12.** The process of claim 9 wherein the liquid enhancing agent contains a substantially inert liquid diluent.

**13.** The process of claim 9 wherein the liquid diluent is selected from the group consisting of water, inert hydrocarbon solvents, 1,2-dichloroethane, and trichlorotrifluoroethane.

**14.** The process of claim 9 wherein the swelling agent is removed from the treated layer by evaporation.

**15.** The process of claim 9 wherein each projected beam subtends an angle up to 70° from the normal to the plane of the layers sides.

**16.** The process of claim 9 wherein the irradiated reflection hologram in step D is heated and the solid recording medium contains an added crosslinking monomer containing at least two terminal ethylenically unsaturated groups.

**17.** The process of claim 16 wherein the crosslinking monomer is diacrylate or dimethacrylate of a bisphenol-A epoxy adduct.

**18.** The process of claim 9 wherein the irradiated reflection hologram in step D is heated and the unsaturated monomer is a phenoxyalkyl acrylate or methacrylate, a phenol ethoxylate acrylate or methacrylate, a phenyl alkyl acrylate or methacrylate, 2-(1-naphthyloxy)ethyl acrylate, the di(2-acryloxyethyl)ether of bisphenol-A, or ethoxylated bisphenol-A diacrylate.

**19.** The process of claim 9 wherein the irradiated reflection hologram in step D is heated and the ethylenically unsaturated monomer is a mixture of a solid monomer selected from the group consisting of N-vinyl carbazole, 3,6-dibromo-9-vinyl carbazole, 2,4,6-tribromophenyl acrylate or methacrylate, pentachlorophenyl acrylate or methacrylate, 2-naphthyl acrylate or methacrylate, 2-(2-naphthyloxy)ethyl acrylate or methacrylate, the di-(2-acryloxyethyl)ether of tetrabromo-bisphenol-A, and mixtures thereof and a liquid monomer selected from the group consisting of phenoxyethyl acrylate, phenol ethoxylate acrylate, the di(2-acryloxyethyl ether) of bisphenol-A, ethoxylated bisphenol-A diacrylate, 2-(1-naphthyloxy)ethyl acrylate, and mixtures thereof.

**20.** The process of claim 9 in which the irradiated reflection hologram in step D is heated and a plasticizer is also present, which plasticizer is selected from the group consisting of tris(2-ethylhexyl)-phosphate, glyceryl tributyrate, and a compound having the general formula:

$$R_1\overset{\overset{O}{\|}}{C}(OCH_2CH_2)_xO\overset{\overset{O}{\|}}{C}R_2;$$

$$R_1O\overset{\overset{O}{\|}}{C}(CH_2)_y\overset{\overset{O}{\|}}{C}OR_2;\ \text{or}$$

$$R_3(OCH_2CHR_4)_zOH$$

wherein $R_1$ and $R_2$ each is an alkyl group of 1 to 10 carbon atoms, $R_3$ is H or an alkyl group of 8 to 16

carbon atoms, $R_4$ is H or $CH_3$, x is 1-4, y is 2-20, and z is 1-20.

**21.** The process of claim 20 wherein the plasticizer is selected from the group consisting of triethylene glycol dicaprylate, triethyleneglycol bis(2-ethylhexanoate), diethyl adipate, dibutyl adipate, tetraethylene glycol diheptanoate, dibutyl suberate, diethyl sebacate, tris(2-ethylhexyl)phosphate, and glyceryl tributyrate.

**22.** The process of claim 20 in which said plasticizer is substituted for at least a portion of the liquid ethylenically unsaturated monomer.

**23.** Use of substantially solid layers as obtained by any one of the preceding claims in holographic mirrors.

**24.** The use according to claim 23 wherein the holographic mirrors are part of a head-up display.

## Patentansprüche

**1.** Verfahren zur Bildung eines Reflexionshologramms, wobei ein Referenzstrahl kohärenter aktinischer Strahlung und ein Objektstrahl der gleichen kohärenten aktinischen Strahlung von gegenüberliegenden Seiten her in eine Schicht eines Aufzeichnungsmediums eindringen, um ein Interferenzmuster in dem Medium zu erzeugen, welches das Hologramm bildet, dadurch gekennzeichnet, daß das Medium eine im wesentlichen feste, photopolymerisierbare Schicht ist, bestehend im wesentlichen aus:
(a) einem polymeren Bindemittel, ausgewählt aus der Gruppe bestehend aus Polyvinylacetat, Polyvinylbutyral, Polyvinylacetal, Polyvinylformal, Interpolymeren, die wesentliche Abschnitte derselben enthalten, sowie deren Mischungen;
(b) einem ethylenisch ungesättigten Monomer, ausgewählt aus der Gruppe bestehend aus Carbazolhaltigen Monomeren und einem flüssigen Monomer, enthaltend eine oder mehrere Phenyl-, Phenoxy-, Naphthyl-, Naphthyloxy-, heteroaromatische Gruppen, enthaltend bis zu drei aromatische Ringe, Chlor und Brom, und
(c) einem durch die aktinische Strahlung aktivierbaren Photoinitiatorsystem.

**2.** Verfahren nach Anspruch 1, wobei das flüssige Monomer ausgewählt ist aus der Gruppe bestehend aus Phenoxyethylacrylat, Phenolethoxylatmonoacrylat, dem Bis(2-acryloxyethyl)ether von Bisphenol A, ethoxyliertem Bisphenol-A-diacrylat, 2-(1-Naphthyloxy)ethylacrylat und deren Mischungen.

**3.** Verfahren nach Anspruch 2, wobei das ethylenisch ungesättigte Monomer eine Mischung eines festen Monomers, ausgewählt aus der Gruppe bestehend aus N-Vinylcarbazol, 3,6-Dibrom-9-vinylcarbazol, 2,4,6-Tribromphenylacrylat oder -methacrylat, Pentachlorphenylacrylat oder -methacrylat, 2-Naphthylacrylat oder -methacrylat, 2-(2-Naphthyloxy)ethylacrylat oder -methacrylat, dem Bis(2-acryloxyethyl)-ether von Tetrabrombisphenol A und deren Mischungen; und eines flüssigen Monomers ist, ausgewählt aus der Gruppe bestehend aus Phenoxyethylacrylat, Phenolethoxylatacrylat, dem Bis(2-acryloxyethyl)-ether von Bisphenol A, ethoxyliertem Bisphenol-A-diacrylat, 2-(1-Naphthyloxy)ethylacrylat und deren Mischungen.

**4.** Verfahren nach Anspruch 1, wobei auch ein Weichmacher vorhanden ist, welcher ausgewählt ist aus der Gruppe bestehend aus Tris(2-ethylhexyl)phosphat, Glyceryltributyrat und einer Verbindung der allgemeinen Formel

$$R_1\overset{\displaystyle O}{\overset{\|}{C}}(OCH_2CH_2)_xO\overset{\displaystyle O}{\overset{\|}{C}}R_2 \ ,$$

$$R_1O\overset{\displaystyle O}{\overset{\|}{C}}(CH_2)_y\overset{\displaystyle O}{\overset{\|}{C}}OR_2 \quad \text{oder}$$

$$R_3(OCH_2CHR_4)_zOH \ ,$$

worin $R_1$ und $R_2$ jeweils eine Alkyl-Gruppe mit 1 bis 10 Kohlenstoff-Atomen ist, $R_3$ H oder eine Alkyl-Gruppe mit 8 bis 16 Kohlenstoff-Atomen ist, $R_4$ H oder $CH_3$ ist, x 1-4, y 2-20 und z 1-20 ist.

**5.** Verfahren nach Anspruch 4, wobei der Weichmacher ausgewählt ist aus der Gruppe bestehend aus Triethylenglycoldicaprylat, Triethylenglycolbis(2-ethylhexanoat), Diethyladipat, Dibutyladipat, Tetraethylenglycoldiheptanoat, Dibutylsuberat, Diethylsebacat, Tris(2-ethylhexyl)phosphat, und Glyceryltributyrat.

**6.** Verfahren nach Anspruch 4, wobei wenigstens ein Teil des flüssigen ethylenisch ungesättigten Monomers durch den Weichmacher ersetzt ist.

**7.** Verfahren nach Anspruch 1, wobei die feste photopolymerisierbare Schicht ein zugesetztes vernetzendes Monomer enthält, das zwei oder mehr endständige ethylenisch ungesättigte Gruppen enthält.

**8.** Verfahren nach Anspruch 7, wobei das vernetzende Monomer ein Diacrylat oder Dimethacrylat eines Bisphenol-A-epoxy-Addukts ist.

**9.** Verfahren zur Bildung und Verstärkung eines Reflexionshologramms in einem im wesentlichen festen, photopolymerisierbaren Aufzeichnungsmedium, umfassend:

A. Projizieren eines Referenzstrahls kohärenter aktinischer Strahlung auf eine erste Seite des Aufzeichnungsmediums, das im wesentlichen besteht aus:

(1) einem polymeren Bindemittel, ausgewählt aus der Gruppe bestehend aus Polyvinylacetat, Polyvinylbutyral, Polyvinylacetal, Polyvinylformal, Interpolymeren, die wesentliche Abschnitte derselben enthalten, sowie deren Mischungen;

(2) einem ethylenisch ungesättigten Monomer, ausgewählt aus der Gruppe bestehend aus Carbazol-haltigen Monomeren und einem flüssigen Monomer, enthaltend eine oder mehrere Phenyl-, Phenoxy-, Naphthyl-, Naphthyloxy-, heteroaromatische Gruppen, enthaltend bis zu drei aromatische Ringe, Chlor und Brom, und

(3) einem durch die aktinische Strahlung aktivierbaren Photoinitiatorsystem;

B. Projizieren eines Objektstrahls der gleichen kohärenten aktinischen Strahlung ungefähr in entgegengesetzter Richtung zum Referenzstrahl auf eine zweite Seite der photopolymerisierbaren Schicht, so daß er den Referenzstrahl in einer Ebene innerhalb der Schicht schneidet, wodurch ein Reflexionshologramm gebildet wird;

C. Bestrahlen der belichteten photopolymerisierbaren Schicht mit einer einheitlichen Quelle aktinischer Strahlung; und

D. entweder Behandeln des bestrahlten Reflexionshologramms mit einem flüssigen Verstärkungsmittel, bei dem es sich um ein Quellmittel für die photopolymerisierte Schicht handelt, oder Erwärmen des bestrahlten Reflexionshologramms eine Zeitlang auf eine Temperatur von wenigstens 50 °C, um das Reflexionsvermögen des Hologramms zu verstärken.

**10.** Verfahren nach Anspruch 9, wobei das flüssige Verstärkungsmittel eine polare organische Flüssigkeit enthält, ausgewählt aus der Gruppe bestehend aus einem Alkohol, einem Keton, einem Aldehyd, einem Glycolalkylether, einem Ester, einem flüssigen Monomer und deren Mischungen.

**11.** Verfahren nach Anspruch 10, wobei das flüssige Verstärkungsmittel ausgewählt ist aus der Gruppe bestehend aus 1-Propanol, Methanol, Ethanol, 2-Propanol, Aceton, Methylethylketon, Cyclohexanon,

Benzaldehyd, Ethylacetat, Butylbenzoat, Phenoxyethylacrylat, Phenolethoxylatacrylat, ethoxyliertem Bisphenol-A-diacrylat, und deren Mischungen.

**12.** Verfahren nach Anspruch 9, wobei das flüssige Verstärkungsmittel ein im wesentlichen inertes flüssiges Verdünnungsmittel enthält.

**13.** Verfahren nach Anspruch 9, wobei das flüssige Verdünnungsmittel ausgewählt ist aus der Gruppe bestehend aus Wasser, inerten Kohlenwasserstoff-Lösuingsmitteln, 1,2-Dichlorethan und Trichlortrifluorethan.

**14.** Verfahren nach Anspruch 9, wobei das Quellmittel durch Verdampfen aus der behandelten Schicht entfernt wird.

**15.** Verfahren nach Anspruch 9, wobei jeder projizierte Strahl einen Winkel von bis zu 70° mit der Senkrechten zur Ebene der Schichtenseiten einschließt.

**16.** Verfahren nach Anspruch 9, wobei das bestrahlte Reflexionshologramm in Schritt D erwärmt wird und das feste Aufzeichnungsmedium ein zugesetztes vernetzendes Monomer enthält, das wenigstens zwei endständige ethylenisch ungesättigten Gruppen enthält.

**17.** Verfahren nach Anspruch 16, wobei das vernetzende Monomer ein Diacrylat oder Dimethacrylat eines Bisphenol-A-epoxy-Addukts ist.

**18.** Verfahren nach Anspruch 9, wobei das bestrahlte Reflexionshologramm in Schritt D erwärmt wird und das ungesättigte Monomer ein Phenoxyalkylacrylat oder -methacrylat, ein Phenolethoxylatacrylat oder -methacrylat, ein Phenylalkylacrylat oder -methacrylat, 2-(1-Naphthyloxy)ethylacrylat, der Bis(2-acryloxyethyl)ether von Bisphenol A or ethoxyliertes Bisphenol-A-diacrylat ist.

**19.** Verfahren nach Anspruch 9, wobei das bestrahlte Reflexionshologramm in Schritt D erwärmt wird und das ungesättigte Monomer eine Mischung eines festen Monomers, ausgewählt aus der Gruppe bestehend aus N-Vinylcarbazol, 3,6-Dibrom-9-vinylcarbazol, 2,4,6-Tribromphenylacrylat oder -methacrylat, Pentachlorphenylacrylat oder -methacrylat, 2-Naphthylacrylat oder -methacrylat, 2-(2-Naphthyloxy)ethylacrylat oder -methacrylat, dem Bis(2-acryloxyethyl)ether von Tetrabrombisphenol A und deren Mischungen, und eines flüssigen Monomers ist, ausgewählt aus der Gruppe bestehend aus Phenoxyethylacrylat, Phenolethoxylatacrylat, dem Bis(2-acryloxyethyl)ether von Bisphenol A, ethoxyliertem Bisphenol-A-diacrylat, 2-(1-Naphthyloxy)ethylacrylat und deren Mischungen.

**20.** Verfahren nach Anspruch 9, wobei das bestrahlte Reflexionshologramm in Schritt D erwärmt wird und auch ein Weichmacher vorhanden ist, welcher ausgewählt ist aus der Gruppe bestehend aus Tris(2-ethylhexyl)phosphat, Glyceryltributyrat und einer Verbindung der allgemeinen Formel

$$R_1\overset{\overset{O}{\|}}{C}(OCH_2CH_2)_xO\overset{\overset{O}{\|}}{C}R_2 \quad ,$$

$$R_1O\overset{\overset{O}{\|}}{C}(CH_2)_y\overset{\overset{O}{\|}}{C}OR_2 \quad \text{oder}$$

$$R_3(OCH_2CHR_4)_zOH \quad ,$$

worin $R_1$ und $R_2$ jeweils eine Alkyl-Gruppe mit 1 bis 10 Kohlenstoff-Atomen ist, $R_3$ H oder eine Alkyl-Gruppe mit 8 bis 16 Kohlenstoff-Atomen ist, $R_4$ H oder $CH_3$ ist, x 1-4, y 2-20 und z 1-20 ist.

**21.** Verfahren nach Anspruch 20, wobei der Weichmacher ausgewählt ist aus der Gruppe bestehend aus Triethylenglycoldicaprylat, Triethylenglycolbis(2-ethylhexanoat), Diethyladipat, Dibutyladipat, Tetraethylenglycoldiheptanoat, Dibutylsuberat, Diethylsebacat, Tris(2-ethylhexyl)phosphat, und Glyceryltributyrat.

**22.** Verfahren nach Anspruch 20, wobei wenigstens ein Teil des flüssigen ethylenisch ungesättigten Monomers durch den Weichmacher ersetzt ist.

**23.** Verwendung der im wesentlichen festen Schichten, wie erhalten nach irgendeinem der vorstehenden Ansprüche, in holographischen Spiegeln.

**24.** Verwendung nach Anspruch 23, wobei die holographischen Spiegel Teil einer Frontscheibenanzeige (Headup-Display) sind.

**Revendications**

**1.** Un procédé pour la formation d'hologramme de réflexion dans lequel un faisceau de référence du rayonnement actinique cohérent et un faisceau objet du même rayonnement actinique cohérent pénètre dans une couche de milieu d'enregistrement à partir de faces opposées de façon à créer un motif d'interférence dans le milieu qui forme l'hologramme, caractérisé en ce que le milieu est une couche photopolymérisable pratiquement solide consistant essentiellement en:

(a) un liant polymère choisi dans le groupe consistant en acétate de polyvinyle, polyvinylbutyral, polyvinylacétal, polyvinylformal, interpolymères contenant des segments majeurs de ceux-ci et leurs mélanges;

(b) un monomère insaturé éthyléniquement choisi dans le groupe consistant en monomères contenant un carbazole et un monomère liquide contenant un ou plusieurs groupes phényle, phénoxy, naphtyl, naphtyloxy, hétéroaromatique contenant jusqu'à trois cycles aromatiques, atomes de chlore et de brome; et

(c) un système photoinitiateur pouvant être activé par le rayonnement actinique.

**2.** Le procédé selon la revendication 1, dans lequel le monomère liquide est choisi dans le groupe consistant en acrylate de phénoxyéthyle, éthoxylate monoacrylate de phénol, di(2-acryloxyéthyl)éther de bisphénol-A, diacrylate de bisphénol-A éthoxylé, acrylate de 2-(1-naphtyloxy)éthyle, et leurs mélanges.

**3.** Le procédé selon la revendication 2, dans lequel le monomère insaturé éthyléniquement est un mélange d'un monomère solide choisi dans le groupe consistant en N-vinylcarbazole, 3,6-dibromo-9-vinylcarbazole, acrylate ou méthacrylate de 2,4,6-tribromophényle, acrylate ou méthacrylate de pentachlorophényle, acrylate ou méthacrylate de 2-naphtyle, acrylate ou méthacrylate de 2-(2-naphtyloxy)-éthyle, di(2-acryloxyéthyl)éther de tétrabromo-bisphénol-A et leurs mélanges; et d'un monomère liquide choisi dans le groupe consistant en acrylate de phénoxyéthyle, éthoxylate acrylate de phénol, di(2-acryloxyéthyl)éther de bisphénol-A, diacrylate de bisphénol-A éthoxylé, acrylate de 2-(1-naphtyloxy)-éthyle et leurs mélanges.

**4.** Le procédé selon la revendication 1, dans lequel un plastifiant est également présent, lequel plastifiant est choisi dans le groupe consistant en tris(2-éthylhexyl)phosphate, tributyrate de glycéryle et un composé de formules générales:

$$R_1\overset{O}{\overset{\|}{C}}(OCH_2CH_2)_xO\overset{O}{\overset{\|}{C}}R_2 \; ; \quad R_1O\overset{O}{\overset{\|}{C}}(CH_2)_y\overset{O}{\overset{\|}{C}}OR_2 \; ; \text{ ou } R_3(OCH_2CHR_4)_zOH$$

dans lesquelles:

$R_1$ et $R_2$ sont chacun un groupe alkyle ayant 1 à 10 atomes de carbone;
$R_3$ est un atome d'hydrogène ou un groupe alkyle ayant 8 à 16 atomes de carbone;
$R_4$ est un atome d'hydrogène ou un groupe $CH_3$;
x est égal à 1 à 4;

y est égal à 2 à 20; et
z est égal à 1 à 20.

**5.** Le procédé selon la revendication 4, dans lequel le plastifiant est choisi dans le groupe consistant en dicaprylate de triéthylèneglycol, bis(2-éthylhexanoate) de triéthylèneglycol, adipate de diéthyle, adipate de dibutyle, diheptanoate de tétraéthylèneglycol, subérate de dibutyle, sébaçate de diéthyle, tris(2-éthylhexyl)phosphate et tributyrate de glycéryle.

**6.** Le procédé selon la revendication 4, dans lequel ce plastifiant remplace au moins une partie du monomère liquide insaturé éthyléniquement.

**7.** Le procédé selon la revendication 1, dans lequel la couche photopolymérisable solide contient un monomère de réticulation ajouté contenant deux ou plusieurs groupes terminaux insaturés éthyléniquement.

**8.** Le procédé selon la revendication 7, dans lequel le monomère de réticulation est un diacrylate ou un diméthacrylate d'un produit d'addition d'époxy et de bisphénol-A.

**9.** Un procédé pour la formation et l'amélioration d'un hologramme de réflexion dans un milieu d'enregistrement photopolymérisable pratiquement solide, le procédé comprenant:

A. la projection d'un faisceau de référence de rayonnement actinique cohérent sur une première face du milieu d'enregistrement, qui consiste essentiellement en:

(1) un liant polymère choisi dans le groupe consistant en acétate de polyvinyle, polyvinylbutyral, polyvinylacétal, polyvinylformal, interpolymères contenant des segments majeurs de ceux-ci et leurs mélanges;

(2) un monomère insaturé éthyléniquement, choisi dans le groupe consistant en monomères contenant un carbazole et un monomère liquide contenant un ou plusieurs groupes phényle, phénoxy, naphtyl, naphtyloxy, hétéroaromatique contenant jusqu'à trois cycles aromatiques, atomes de chlore et de brome; et

(3) un système photoinitiateur pouvant être activé par le rayonnement actinique;

B. la projection d'un faisceau objet du même rayonnement actinique cohérent à peu près dans une direction opposée à celle du faisceau de référence sur une seconde face de la couche photopolymérisable de façon à couper le faisceau de référence dans un plan à l'intérieur de la couche de façon à former un hologramme de réflexion;

C. l'irradiation de la couche photopolymérisable pourvue d'une image avec une source uniforme de rayonnement actinique; et

D. soit le traitement de l'hologramme de réflexion irradié avec un agent liquide d'amélioration qui est un agent gonflant pour la couche photopolymérisée, soit le chauffage de l'hologramme de réflexion irradié à une température d'au moins 50°C pendant une période de temps pour améliorer la réflectivité de l'hologramme.

**10.** Un procédé selon la revendication 9, dans lequel l'agent liquide d'amélioration contient un liquide organique polaire choisi dans le groupe consistant en un alcool, une cétone, un aldéhyde, un éther alkylique de glycol, un ester, un monomère liquide et leurs mélanges.

**11.** Le procédé selon la revendication 10, dans lequel l'agent liquide d'amélioration est choisi dans le groupe consistant en 1-propanol, méthanol, éthanol, 2-propanol, acétone, méthyléthylcétone, cyclohexanone, benzaldéhyde, acétate d'éthyle, benzoate de butyle, acrylate de phénoxyéthyle, éthoxylate acrylate de phénol, diacrylate de bisphénol-A éthoxylé et leurs mélanges.

**12.** Le procédé selon la revendication 9, dans lequel l'agent liquide d'amélioration contient un diluant liquide pratiquement inerte.

**13.** Le procédé selon la revendication 9, dans lequel le diluant liquide est choisi dans le groupe consistant en eau, solvants hydrocarbonés inertes, 1,2-dichloroéthane et trichlorotrifluoroéthane.

**14.** Le procédé selon la revendication 9, dans lequel l'agent gonflant est éliminé de la couche traitée par évaporation.

**15.** Le procédé selon la revendication 9, dans lequel chaque faisceau projeté sous-tend un angle allant jusqu'à 70° de la normale par rapport au plan des faces de la couche.

**16.** Le procédé selon la revendication 9, dans lequel l'hologramme de réflexion irradié dans l'étape D est chauffé et le milieu d'enregistrement solide contient un monomère de réticulation ajouté contenant au moins deux groupes terminaux insaturés éthyléniquement.

**17.** Le procédé selon la revendication 16, dans lequel le monomère de réticulation est un diacrylate ou un diméthacrylate d'un produit d'addition d'époxy et de bisphénol-A.

**18.** Le procédé selon la revendication 9, dans lequel l'hologramme de réflexion irradié dans l'étape D est chauffé et le monomère insaturé est un acrylate ou méthacrylate de phénoxyalkyle, un éthoxylate acrylate ou méthacrylate de phénol, un acrylate ou méthacrylate de phénylalkyle, un acrylate de 2-(1-naphtyloxy)éthyle, le di(2-acryloxyéthyl)éther de bisphénol-A, ou le diacrylate de bisphénol-A éthoxylé.

**19.** Le procédé selon la revendication 9, dans lequel l'hologramme de réflexion irradié dans l'étape D est chauffé et le monomère insaturé éthyléniquement est un mélange d'un monomère solide choisi dans le groupe consistant en N-vinylcarbazole, 3,6-dibromo-9-vinylcarbazole, acrylate ou méthacrylate de 2,4,6-tribromophényle, acrylate ou méthacrylate de pentachlorophényle, acrylate ou méthacrylate de 2-naphtyle, acrylate ou méthacrylate de 2-(2-naphtyloxy)éthyle, di(2-acryloxyéthyl)éther du tétrabromo-bisphénol-A et leurs mélanges, et d'un monomère liquide choisi dans le groupe consistant en acrylate de phénoxyéthyle, éthoxylate acrylate de phénol, di(2-acryloxyéthyl)éther de bisphénol-A, diacrylate de bisphénol-A éthoxylé, acrylate de 2-(1-naphtyloxy)éthyle et leurs mélanges.

**20.** Le procédé selon la revendication 9, dans lequel l'hologramme de réflexion irradié dans l'étape D est chauffé et un plastifiant est également présent, lequel plastifiant est choisi dans le groupe consistant en tris(2-éthylhexyl)phosphate, tributyrale de glycéryle et un composé de formules générales:

$$R_1\overset{O}{\overset{\|}{C}}(OCH_2CH_2)_x O\overset{O}{\overset{\|}{C}}R_2 \ ; \quad R_1O\overset{O}{\overset{\|}{C}}(CH_2)_y\overset{O}{\overset{\|}{C}}OR_2 \ ; \ \text{ou} \ R_3(OCH_2CHR_4)_zOH$$

dans lesquelles:

| | |
|---|---|
| $R_1$ et $R_2$ | sont chacun un groupe alkyle ayant 1 à 10 atomes de carbone; |
| $R_3$ | est un atome d'hydrogène ou un groupe alkyle ayant 8 à 16 atomes de carbone; |
| $R_4$ | est un atome d'hydrogène ou un groupe $CH_3$; |
| x | est égal à 1 à 4; |
| y | est égal à 2 à 20; et |
| z | est égal à 1 à 20. |

**21.** Le procédé selon la revendication 20, dans lequel le plastifiant est choisi dan le groupe consistant en dicaprylate de triéthylèneglycol, bis(2-éthylhexanoate) de triéthylèneglycol, adipate de diéthyle, adipate de dibutyle, diheptanoate de tétraéthylèneglycol, subérate de dibutyle, sébaçate de diéthyle, tris(2-éthylhexyl)phosphate et tributyrate de glycéryle.

**22.** Le procédé selon la revendication 20, dans lequel ce plastifiant remplace au moins une partie du monomère liquide insaturé éthyléniquement.

**23.** Utilisation de couches pratiquement solides telles qu'obtenues par l'une quelconque des revendications précédentes, dans des miroirs holographiques.

**24.** Utilisation selon la revendication 23, dans laquelle les miroirs holographiques font partie d'un dispositif d'affichage frontal.